# EUROPEAN PATENT SPECIFICATION

(11) **EP 4 275 178 B1**
(45) Date of publication and mention of the grant of the patent: **17.04.2024**
(21) Application number: 22716898.6
(22) Date of filing: 18.03.2022
(51) Int. Cl.: G06T 17/00

(54) **COMPUTER-IMPLEMENTED AUGMENTATION OF INTERIOR ROOM MODELS**
COMPUTERIMPLEMENTIERTE ERWEITERUNG VON INNENRAUMMODELLEN
AUGMENTATION MISE EN OEUVRE PAR ORDINATEUR DE MODÈLES DE PIÈCE INTÉRIEURE

(43) Date of publication of application: 15.11.2023
(73) Proprietor: Synthetic Dimension GmbH, 5412 Puch bei Hallein (AT)
(72) Inventor: HOFER, Christoph, 5020 Salzburg (AT); KURZ, Manuel, 5440 Golling (AT); GADERMAYR, Michael, 5411 Oberalm (AT)
(74) Representative: Maiwald GmbH
(86) International application number: PCT/EP2022/057195
(87) International publication number: WO 2023/174559

(56) References cited:
- SEBASTIAN OCHMANN ET AL: "Automatic reconstruction of parametric building models from indoor point clouds", COMPUTERS & GRAPHICS, vol. 54, 1 February 2016 (2016-02-01), pages 94-103, XP055458626,
- BARAZZETTI LUIGI ED - TRAPPEY AMY J C ET AL: "Parametric as-built model generation of complex shapes from point clouds", ADVANCED ENGINEERING INFORMATICS, ELSEVIER, AMSTERDAM, NL, vol. 30, no. 3, 10 May 2016 (2016-05-10), pages 298-311, XP029688227, ISSN: 1474-0346, DOI: 10.1016/J.AEI.2016.03.005

## Description

### Technical Field

The present disclosure generally relates to the field of computer-implemented modeling of an interior room, for example for generating or composing a virtual reality representation or scene of the interior room. In particular, the present disclosure relates to a computer-implemented method of reconstructing an interior room based on and/or using sensor data of one or more image sensors. Moreover, the present disclosure relates to a computing system, a computer program and a corresponding computer-readable medium for carrying out steps of the aforementioned method.

### Technical Background

Computer-implemented or computer-driven technologies for modeling environments have been increasingly developed and successfully applied in many different fields of technology and industry. Typical examples are virtual reality (VR) or augmented reality (AR) technologies, where for example sensor data of one or more sensors, such as image sensors capturing an environment of a user, can be used to generate, supplement or enrich virtual scenes simulating or modeling the environment based on one or more computer-generated models. Other examples include so-called mixed reality (MR) or extended reality (XR) technologies, where elements of real environments and virtual environments are typically merged to generate scenes or corresponding models representing new environments.

Nowadays, such techniques and technologies or certain aspects thereof are applied in many different fields of technology already at routine basis. Non-limiting examples and exemplary use cases comprise medical applications, such as augmented reality operating theatres or assistive technology in the medical field, educational or training applications, such as flight simulators or the like, gaming industry, virtual meeting or conference rooms, and autonomous driving.

Depending on the actual use case or application, different hard- and/or software components may be involved, such as one or more sensors capturing sensor data, one or more computing devices for processing the sensor data or other data, one or more devices for displaying a virtual scene, and/or one or more devices allowing a user to interact with the generated virtual scene. While some applications may require dedicated hardware, such as VR or AR glasses or goggles, for displaying or visualizing a virtual scene and allowing a user to interact with the scene, other applications can be run on regular computing devices or even portable user devices, such as smartphones, tablets or notebooks.

Further, for actually computing or generating models representing one or more scenes of a particular environment, non-learning based approaches of computing two- or three-dimensional models of the scene or certain aspects thereof have been proposed and used. Increasingly, however, such non-learning based approaches are supplemented and/or replaced by artificial intelligence (Al) based and/or learning-based methods, such as machine learning and deep learning methods, where an artificial intelligence algorithm, engine, module or circuitry is trained with corresponding training data to model one or more particular aspects of an environment. Therein, a quality, robustness and user experience may depend on the data available and used to generate or compute the models of the scene or environment, such as for example on the sensor data, on the training data used to train the Al-based module, and on other software or hardware components potentially involved in computing the models, visualizing them and allowing a user to interact with them. Also, certain environments may be particularly challenging in terms of generating realistic and high-quality virtual scenes or corresponding models at a high level of user-experience. An example of such environments are interior rooms, such as rooms in a house or building. Modeling an interior room may be particularly challenging in terms of accurately reconstructing the room, and optionally one or more objects arranged therein, based on generating or computing a corresponding model of the room, in terms of visualizing the reconstructed room based on or using the model, and in terms of enabling a user to interact with such virtual representation, for example to alter or modify the virtual representation of a room displayed on a user device. Parametric as-built model generation of complex shapes from point clouds for buildings is known from BARAZZETTI LUIGI ED - TRAPPEY AMY J C et al.: "Parametric as-built model generation of complex shapes from point clouds", 10 May 2016, as published in ADVANCED ENGINEERING INFORMATICS, ELSEVIER, AMSTERDAM, NL, volume 30, no. 3, pages 298-311. Automatic reconstruction of parametric building models from indoor point clouds is known from Sebastian Ochmann et al.: "Automatic reconstruction of parametric building models from indoor point clouds", Feb 2016, as published in COMPUTERS & GRAPHICS, volume 54, pages 94-103.

### Summary

It may, therefore, be desirable to provide for improved computer-implemented methods, corresponding devices, systems and techniques for modeling an interior room.

This is achieved by the subject matter of the independent claims, wherein further embodiments are incorporated in the dependent claims and the following description.

As used herein, computer-implemented modeling of an interior room can comprise any computer-driven task indirectly or directly related to one or more of generating, visualizing and modifying one or more models representative of the interior room. In other words, computer-implemented modeling of an interior room is to be construed broadly in the context of the present disclosure. For example, modeling an interior room can include computing one or more models representative of the interior room, computing one or more parameters of one or more models, computing data associated with one or more models representative of the interior room, reconstructing the interior room, composing a virtual representation or scene of the room based on one or more computer-generated models, visualizing a reconstructed interior room or corresponding one or more computer-generated models, receiving user feedback related to a visual representation of the room or corresponding one or more computer-generated models, as well as modifying, altering and/or replacing the one or more computer-generated models. Alternatively or additionally, computer-implemented modeling of the interior room, as described herein, can include aspects of generating training data for training an Al-based engine, module, circuitry or algorithm for any one or more the aforementioned tasks as well as using such training data for the actual training of an Al-based engine. Also, it is noted that, while the present disclosure may particularly focus at certain instances on modeling interior rooms, for example for interior design purposes or room optimization purposes, the present disclosure or parts thereof may also be used to advantage in other applications in the fields of virtual, augmented and mixed reality as well as in related or similar technical fields.

Aspects of the present disclosure relate to a computer-implemented method of reconstructing an interior room. Moreover, various aspects of the present disclosure relate to a computer system for carrying out steps of one or more of the methods according to one or more aspects of the present disclosure. Further aspects of the present disclosure relate to a computer program and a computer-readable medium storing such program(s) for carrying out steps of one or more of the methods according to one or more aspects of the present disclosure.

According to the present disclosure, there is provided a computer-implemented method of modeling, reconstructing an interior room. The method comprises:
- receiving sensor data indicative of at least one image of at least a part of a room acquired with at least one image sensor of a user device;
- determining, based on the sensor data, at least a part of a point cloud representative of the at least part of the room and representative of one or more objects arranged in the room, wherein at least one of the one or more objects is associated with an item of furniture arranged in the room;
- detecting, based on the determined point cloud, one or more objects arranged in the room;
- associating the detected one or more objects with one or more reference objects indicative of one or more reference items of furniture;
- determining one or more parametric models for and/or representative of the detected one or more objects; and
- reconstructing at least a part of the room based on the determined one or more parametric models for the detected one or more objects;

the method further comprises determining, based on processing the point cloud, sensor data and/or one or more images indicative of the one or more objects arranged in the room, materials of the one or more objects arranged in the room;
retrieving, from a database storing a plurality of reference materials of reference objects, materials data resembling the determined one or more materials of one or more objects arranged in the room;
reconstructing the room based on the retrieved material data,

A further aspect of the present disclosure relates to a computing systems configured to perform steps of the method according to the present disclosure, as described hereinabove and hereinbelow.

Therein, the computing system may comprise at least one computing device with a processing circuitry including one or more processors for data processing.

Optionally, the computing system described herein may include at least one user device communicatively couplable to one or more servers, wherein the user device may include at least one image sensor for acquiring sensor data.

A computing device, as used herein, may refer to a user device, server, a plurality of servers, a server network and/or any other computing device suitable and/or configured to perform one or more steps of one or more methods according to one or more aspects of the present disclosure, as described hereinabove and hereinbelow. Accordingly, one or more further aspects of the present disclosure can relate to one or more user devices and/or one or more servers configured to perform steps of one or more of the methods according to one or more aspects of the present disclosure, as described hereinabove and hereinbelow.

A further aspect of the present disclosure relates to a computer program, which, when executed by one or more processors of a computing system and/or computing device, instruct the computing system and/or computing device, for example one or more of a server and/or a user device, to perform steps of the method according to the present disclosure, as described hereinabove and hereinbelow.

A further aspect of the present disclosure relatea to a computer-readable medium having stored thereon a computer program, which, when executed by one or more processors of a computing system and/or computing device, instruct the computing system and/or computing device, for example one or more of a server and/or a user device, to perform steps of the method according to the present disclosure, as described hereinabove and hereinbelow.

As will described in more detail hereinbelow, particular aspects of the present disclosure, such as one or more of the aforementioned methods according to various aspects of the present disclosure, may be focused on particular components or features of an overall system and method of modeling an interior room, which components or features may interoperate and interact with each other to form the overall system or method. It is noted, however, that features, functionalities and/or components of an overall system or method of modeling an interior room may be adapted, modified, or otherwise changed, for example according to particular use cases or applications of the system. Accordingly, any one or more of the aforementioned methods according to various aspects of the present disclosure can be combined with one another and/or with any other aspect of the present disclosure, for example to form an overall system or method of modeling an interior room.

In the following, various examples, embodiments and exemplary implementations of any one or more aspects of the present disclosure, in particular the aforementioned methods according to various aspects of the present disclosure, are described. Also with respect to examples, embodiments and exemplary implementations described herein, it is emphasized that these can be combined with one another and/or with any one or more aspects of the present disclosure. While certain embodiments may be described in the following with reference to a singular method or "the method" of the present disclosure, this includes a plurality of methods according the present disclosure.

As used herein, the interior room may generally refer to a room in a building, house or any other surrounding, wherein the room may have a certain interior volume and geometry defined by one or more boundaries of the room, such as one or more walls arranged on one or more sides of the room, a ceiling arranged at a top of the room, and a floor arranged at a bottom. Therein, directions and orientations, such as "top and bottom" may refer to directions and orientations in the Earth's gravity field. It is emphasized that an interior room envisaged in the present disclosure can include one or more open sides. Also, the interior room can have an arbitrary shape, geometry and/or size.

Further, as used herein, receiving sensor data of at least one image sensor may comprise retrieving the sensor data from a data storage, for example from a data storage of the user device. Therein, the sensor data may be received by the user device and/or one or more servers operatively and/or communicatively coupled or couplable with the user device.

In the context of the present disclosure the user device may refer to a computing device including a processing circuitry with one or more processor for data processing. The user device may refer to a portable or mobile device, such as a smartphone, tablet or notebook. Alternatively, the user device may refer to a stationary computing device, such as a personal computer or the like. Any other type of user device is envisaged by the present disclosure.

Similarly, the one or more servers referred to herein may denote one or more computing devices including a processing circuitry with one or more processors for data processing. Also the one or more servers referred to herein may refer to portable or stationary devices. It is noted that any reference to a single server or computing device hereinabove and hereinbelow includes a plurality of servers or computing devices.

The user device may optionally comprise one or more image sensors, for example one or more cameras with one or more image sensors, for acquiring the sensor data. Alternatively or additionally, the user device may be configured for retrieving sensor data from an external data storage and/or an external camera or image sensor communicatively and/or operatively couplable with the user device. For example, the user device may comprise a communication circuitry for receiving sensor data from an external camera and/or data storage. Such communication circuitry may be configured for wireless and/or wired communication. Alternatively or additionally, the user device may comprise a communication circuitry for receiving data from one or more servers and/or for transmitting data, e.g. the sensor data, to one or more servers.

In the context of the present disclosure, the sensor data may refer to and/or be understood as raw sensor data, for example sensor data as directly acquired and/or recorded with the one or more image sensors. Accordingly, the sensor data (or raw sensor data) can refer to data recorded directly by means of the one or more image sensors, which may be contrasted with pre-processed or otherwise processed images or image data. Generally, the sensor data can refer to data of any type and format, which data include optical information about the interior room, such as lossless image data, compressed image data, lossy image data, pixel data, point cloud data, or any other data.

According to an embodiment, the method further includes acquiring and/or capturing the sensor data with the at least one image sensor of the user device. In other words, the sensor data may be acquired and/or captured using the user device.

In an exemplary implementation, at least a part of the sensor data may be acquired during movement of the user device through the room. For instance, a user may carry the user device through the interior room and capture one or more images at one or more positions in the room. Accordingly, the sensor data may include the information of image data of a single image captured at a particular position, orientation and/or view angle of the user device with respect to one or more boundaries of the interior room. Alternatively, the sensor data may include or be indicative of a plurality of images captured and/or acquired with the at least one image sensor at one or more positions in the room, for example captured at different positions, orientations and/or view angles of the user device with respect to one or more boundaries of the interior room. Using a plurality of images or corresponding sensor data may further increase a quality and/or precision of reconstructing and/or modeling the interior.

According to an embodiment, the method further comprises analyzing, based on processing the sensor data with a processing circuitry including one or more processors, the sensor data in terms of a suitability of the sensor data to reconstruct the at least part of the room and/or one or more objects arranged in the room.

Therein, the sensor data may be analyzed with a processing circuitry of the user device. Alternatively or additionally, the sensor data may be analyzed with a processing circuitry of a server communicatively couplable to the user device.

According to an embodiment, the method further comprises transmitting the sensor data from the user device to one or more server. As described hereinabove, the user device may include a communication circuitry for communicating and/or exchanging data with one or more servers, for example to bidirectionally exchange data. Therein, the communication circuitry may be configured for wired and/or wireless communication with the one or more servers using one or more communication protocols.

According to an embodiment, the sensor data includes one or more of RGB sensor data (RedGreenBlue, RGB) and multispectral sensor data. Alternatively or additionally, the at least one image sensor includes at least one RGB sensor and/or at least one multispectral image sensor. Generally, any number of image sensors of one or more types of image sensors can be used alone or in combination to generate the image sensor data. This can include monochrome image sensors, color image sensor, RGB image sensors, multispectral image sensors, infrared image sensors, ultraviolet image sensor or any other type of image sensor. Accordingly, the term image sensor may be used herein to broadly refer to any type of sensor configured for acquiring electromagnetic radiation at one or more spectral lengths of the respective radiation.

According to an embodiment, the sensor data includes depth sensor data. Alternatively or additionally, the at least one image sensor includes one or more depth sensors, such as for example a LIDAR sensor and/or stereo camera. Using depth sensor data may particularly allow to precisely determine geometrical parameters of the interior room and/or one or more objects arranged or located therein, such as dimensions of the interior room or one or more boundaries thereof. Hence, using depth sensor data can further increase a quality and precision of the process of reconstructing and/or modeling the interior room.

According to an embodiment, the sensor data includes further sensor data of one or more of a gyroscope, an accelerometer, a radiation sensor, a thermal sensor, a laser sensor, an acoustic sensor, a pressure sensor, a nearfield sensor, and a capacitive sensor. Generally, further sensor data of any one or more further sensors may be combined and/or merged with sensor data of the at least one image sensor to generate the sensor data, for example the sensor data used to determine the point cloud.

According to an embodiment, the point cloud includes a plurality of data points or data elements, each data point or element being associated with one or more spatial coordinates within the room. Therein, the point could may refer to a two-dimensional (2D) point cloud with a plurality of data points or elements in two spatial directions. Alternatively, the point cloud may refer to a three-dimensional (3D) point cloud with a plurality of data points or elements in three spatial directions.

Generally, the point cloud as referred to herein may denote a set of data points or data elements, which set of data points or elements may be representative, indicative and/or descriptive of a geometry of the interior room, a geometry of one or more objects arranged, as well as positional information about the relative orientation and/or position of several objects with respect to one another and with respect to one or more spatial coordinates (e.g. reference points) of one or more boundaries of the room.

According to an embodiment, analyzing the sensor data includes one or more of the following steps:
- deriving the point cloud from the sensor data;
- determining a spatial density of data points of the point cloud;
- determining image blur;
- determining sensor noise;
- determining a distance between the at least one image sensor and an object arranged in the room;
- determining a distance between an object and a boundary of the room;
- determining a distance between two objects arranged in the room;
- determining a translational movement of the user device within the room based on analyzing a plurality of consecutive images captured with the image sensor;
- determining a rotational movement of the user device within the room based on analyzing a plurality of consecutive images; and
- determining a noise of the sensor data.

Generally, one or more geometrical parameters descriptive of a geometry of the interior room and/or descriptive of the one or more objects arranged therein may be computed based on determining one or more of the aforementioned measures and quantities. In particular, one or more geometrical parameters associated with a dimension, size, and one or more extensions of the interior room in one or more spatial directions may be determined, computed and/or calculated based on analyzing the point cloud or the data elements thereof. Alternatively or additionally, one or more geometrical parameters associated with a dimension, size, and one or more extensions of one or more objects in one or more spatial directions may be determined, computed and/or calculated based on analyzing the point cloud or the data elements thereof. Alternatively or additionally, one or more relative geometrical parameters, such as the relative distance between two objects, the relative orientation of two objects with respect to each other, the relative orientation of two boundaries of the room with respect to each other, and/or the relative orientation of one of the objects with respect to a boundary of the room can be determined, computed and/or calculated based on analyzing the point cloud or the data elements thereof in one or more spatial coordinates.

Alternatively or additionally, one or more parameters or indicators related to the actual acquisition and/or recording of sensor data may be determined, such as the translational movement, the rotational movement, image blur or the like.

According to an embodiment, the method further comprises evaluating the sensor data against one or more predefined criteria indicative of a suitability of the sensor data to reconstruct the at least part of the room and/or one or more objects arranged in the room. Therein, the suitability of the sensor data to reconstruct the at least part of the room may correlate with a quality, precision, accuracy and/or uncertainty of one or more geometrical parameters derivable and/or computable based on the sensor data. Alternatively or additionally, one or more parameters related to and/or descriptive of the actual acquisition of sensor data, such as the translational movement, the rotational movement, and/or image blur occurring in a series of consecutive images acquired with the user device during movement may be used to evaluate the sensor data in terms of their suitability to reconstruct the at least part of the room and/or one or more objects arranged in the room.

For instance, it may be determined that a certain geometrical parameter determined based on analyzing the point cloud is associated with or can only be computed with a particular uncertainty or precision. Such computed uncertainty or precision of one or more geometrical parameters descriptive of the geometry of the room and/or one or more objects arranged therein may be used as indicator indicating the suitability (or a level of suitability) of the sensor data to reconstruct the at least part of the room and/or one or more objects arranged in the room.

According to an embodiment, the one or more predefined criteria are indicative of one or more of a threshold value for a spatial density of data points of the point cloud, a threshold value for image blur, a threshold value for sensor noise, a threshold value for a distance between the user device and an object arranged in the room, a threshold value for a distance between an object and a boundary of the room, a threshold value for a distance between two objects arranged in the room, a threshold value for a translational movement of the user device within the room, a threshold value for a rotational movement of the user device within the room, and a threshold value for a noise of the sensor data. Any one or more of the aforementioned parameters, which are also referred to as geometrical parameters and parameters related to the acquisition of sensor data, respectively, may reliably indicate whether or not the sensor data is suitable for reconstructing the room, for example with a predefined accuracy and precision.

Generally, acquisition of the sensor data or at least a part thereof may be performed independently by the user based on acquiring one or more images at one or more positions in the interior room. For instance, a mobile device or smartphone and its integrated one or more sensors, for example one or more image sensors, RGB sensors, multispectral sensors, depth sensors, and/or other sensors, may be configured to record color and/or depth information, and potentially further information or data such as gyroscope data, at one or more positions in the room. Each acquisition of information or sensor data at a particular position may represent a particular scene. Accordingly, a scene may refer to a representation of the room at a particular position and/or view angle relative to one or more boundaries of the room. A plurality of such scenes and corresponding sensor data or information may be generated by walking through the interior room with the user device and acquiring a plurality of images at different positions and/or view angles.

Since typically the user device may be carried in front of the user, the actual procedure of acquiring one or more images may have an influence on a quality and/or informational content of the recorded sensor data, which in turn can affect a quality of reconstructing and/or modeling the interior room and/or one or more objects arranged therein.

For example, a speed or velocity of movement of the user device generally can affect or influence the amount of raw data or sensor data recorded at a given position and/or orientation of the user device per unit time. Accordingly, speed or velocity of movement of the user device can affect a number of points or data elements of the determined point cloud in at least a portion of the point cloud. Accordingly determining a spatial density of points of the point cloud, for example a local spatial density of a subset of data points of the point cloud, can allow to determine a speed or velocity of the user device during acquisition. Further, movement of the user device during image acquisition may affect informational content of depth sensor data with a lower number of depth sensor data elements or points for a given position at higher velocities. Similarly, motion blur of color information contained in the sensor data may increase with increasing speed or velocity of the movement of the user device during recording of the sensor data. Hence, also one or more of the depth sensor data and image blur may indicate a suitability of the sensor data to reconstruct the room.

Furthermore, an extent of shadowing by objects can be minimized by more precise recording. For example, certain movements of the user device during acquisition of the sensor data, such as panning, moving the user device up, moving the user device down, changing a view angle, rotating the user device, and the like can increase an informational content of the sensor data as well as the point cloud determined based thereon.

Furthermore, a distance between the user device or image sensor and an object captured in the image may affect the informational content of the sensor data and an informational content of the point cloud, and hence can influence a quality and precision of reconstructing the room and/or one or more objects arranged therein. For example, by recording sensor data or an image too close to an object, an informational content of the point cloud may at least locally be reduced, as the object may only be visible as homogenous wall in the image and no key or reference points may be detectable on such homogeneous wall. For instance, the user device may have a maximum and/or minimum distance below/above which no reliable sensor data may be delivered. The user device and/or one or more servers may analyse the sensor data, determine distances between objects or elements and compare the determined distances with one or more predefined threshold values for the distance in order to determine whether or not particular sensor data or images are suitable for reconstructing the room.

Accordingly, by analyzing the sensor data, determining one or more geometrical parameters related to the room and/or one or more objects arranged therein, and comparing the determined geometrical parameters to one or more predefined criteria, such as a minimum distance between the user device and an object, an informational content of the sensor data and/or its suitability for reconstructing the room may be assessed. Alternatively or additionally, by analyzing the sensor data, determining one or more parameters related to acquisition of sensor data, such as determining a speed or velocity of the movement of the user device, image blur and/or a spatial density of the point cloud, and by comparing the determined parameters to one or more predefined criteria, such as a maximum speed or velocity of the user device during image acquisition, an informational content of the sensor data and/or its suitability for reconstructing the room may be assessed

According to an embodiment, the method further comprises providing a user-perceptible signal to the user via one or more user interfaces of the user device for guiding the user to acquire one or more images of the at least part of the room and/or for providing feedback to the user about a scanning progress for scanning the room using the user device, for example based on acquiring a plurality of images at one or more positions in the room. The user interface of the user device may be an acoustic user interface, a haptic user interface, an optical or visual user interface, a touch display, or a combination of one or more thereof. Accordingly, the user perceptible signal may refer to any one or more of an acoustic signal, a haptic signal, and a visual or optical signal. Generally, by providing the user-perceptible signal for guiding the user and/or for providing the feedback about the scanning process it may be ensured that the sensor data are correctly acquired and are suitable for reconstructing the room at high quality.

Therein, the user-perceptible signal may comprise one or more instructions to guide the user through a process of acquiring the sensor data, for example one or more images. For example, one or more instructions to move the user device in one or more spatial directions, to rotate the device, to move the device up or down, to pan the device, to slow down a movement, to rotate the user device, and/or to increase a speed of movement may be provided.

Further, the user-perceptible signal for providing feedback about the scanning process may refer to a feedback about a quality of the scanning progress and/or suitability of the acquired sensor data to reconstruct the room. Alternatively or additionally, information about a status of the scanning progress, such as "complete, incomplete or ongoing", may be provided to the user as feedback. Therein, also the feedback may be provided to the user in the form of one or more of an acoustic, haptic and/or visual signal, at one or more user interfaces of the user device.

According to an embodiment, the method further comprises determining and/or selecting the user-perceptible signal based on evaluating the sensor data against one or more predefined criteria indicative of a suitability of the sensor data to reconstruct the at least part of the room and/or an object arranged in the room. Such determination and/or selection of the user-perceptible signal may be determined by the user device or by one or more servers that may provide a corresponding control signal to the user device, such that the user-perceptible signal is provided or output at the user device.

According to an embodiment, the user-perceptible signal includes one or more of an acoustic signal, a visual signal, a message, a notification, a query, a prompt, and a haptic signal. Any other type of signal or any combination thereof is envisaged herein.

According to an embodiment, the user-perceptible signal includes one or more instructions related to one or more of a velocity of the user device during image acquisition, an acquisition angle, an acquisition position within the room, a position relative to one or more objects arranged in the room, an orientation of the user device, and a lighting condition in the room. For instance, one or more instructions to change a speed or velocity of movement, to change a position within the room, to change a view angle, to maintain a certain position, to maintain a certain view angle, to maintain a certain velocity, to change the lighting condition, to maintain a lighting condition, or similar instructions may be provided.

According to an embodiment, the method further comprises determining a scanning progress of the room for scanning the room using the user device. As noted above, this may include determining a status of the scanning progress and/or determining a quality of the scanning progress, for example based on determining the suitability of the sensor data to reconstruct the room.

According to an embodiment, the method further comprises providing a status signal to the user via one or more user interfaces of the user device, the status signal being indicative of the scanning progress. For instance, the status signal may indicate completion of the scanning progress on an arbitrary scale, and/or may indicate whether or not the scanning process is complete or should be repeated.

In an exemplary implementation, the user-perceptible signal for guiding the user and/or for providing feedback about the scanning progress can be provided in real-time or near real-time during acquisition of the sensor data with the user device. To make data acquisition as user-friendly as possible, the user may receive immediate feedback on the scanning progress. In addition or in the alternative, the user may be informed based on the user-perceptible signal, for example, if the movement is too fast or in the event that unfavorable distances, such as a distance below a predetermined minimum or maximum distance to objects, is selected by the user. Also potential shadowing may be pointed out or indicated to the user by providing a corresponding user-perceptible signal.

According to an embodiment, the sensor data may be transmitted from the user device to the server, and the server may be configured to process the sensor data into pre-processed data usable for determining the point cloud. Alternatively or additionally, the method may comprise processing the sensor data at the user device into pre-processed data transmittable to a server.

For example, processing the sensor data into pre-processed data may include one or more of normalizing the sensor data, adjusting and/or modifying a spatial density of data points of a point cloud indicated by the sensor data, adjusting and/or modifying the sensor data in terms of a spatial resolution, adjusting and/or modifying the sensor data in terms of blur, applying blur correction, interpolating the sensor data, extrapolating the sensor data, and applying noise reduction to the sensor

By processing the sensor data into the pre-processed data, for example differences between sensor data of different image sensors may be compensated for, which may further enhance or increase an accuracy and precision of reconstructing the room. Also, the pre-processed data may allow for a more efficient, faster and more effective reconstruction of the room.

According to an embodiment, the sensor data includes RGB or multispectral sensor data indicative of one or more RGB or multispectral images acquired with the at least one image sensor, wherein the method further comprises generating depth sensor data based on the RGB or multispectral sensor data, the depth sensor data being indicative of one or more depth maps associated with the one or more images indicated by the RGB or multispectral sensor data. Generally, the sensor data may be enriched and/or supplemented based on deriving further sensor data from the sensor data, which further sensor data may simulate the data of one or more further sensors, such as one or more further image sensors, depth sensors and/or other types of sensors. Further, the sensor data and the further sensor data derived therefrom may together form or may together be processed into the pre-processed data, which may optionally be determined for determining the point cloud and reconstructing the room.

According to an embodiment, reconstructing the at least part of the room comprises reconstructing, computing, assessing, estimating and/or determining at least a part of a geometry of the room. For example, determining the geometry of the room (also referred to as room geometry herein) may include determining one or more of a shape, a dimension, and at least one extension of one or more boundaries of the room in in at least one spatial direction. Alternatively or additionally, determining the room geometry may include determining the relative orientation, distance and/or position of at least two boundaries of the room with respect to each other. Alternatively or additionally, one or more angles between two boundaries in or along one or more spatial directions may be determined.

According to an embodiment, reconstructing the room comprises determining and/or approximating a geometry of the room based on representing at least one portion of the point cloud with one or more base elements having a predefined geometry and/or shape. For instance, at least a part of the point cloud may be supplemented, substituted and/or replaced by one or more base elements in order to represent the at least one portion of the point cloud.

In an exemplary embodiment, each of the base elements, respectively the one or more base elements, may correspond to, be associated with and/or include a parametric model of predefined geometry and/or shape.

In a non-limiting example, each base element, respectively the one or more base elements, may correspond to, be associated with, and/or include a parametric model for and/or representative of one or more of a plane, a surface, an area, a planar surface, a spherical surface, a cylindrical surface, a conical surface, a curved surface, a polygonal surface, a circle, a circle section, an elliptical surface, a straight line, an arc, a circular arc, and a triangular surface. Accordingly, a base element may be associated with and/or represent a basic geometrical object of predefined basic geometry.

According to an embodiment, the one or more base elements have a two-dimensional or three-dimensional geometry. It is noted that also a plurality of base elements may be selected, wherein at least one may have a two-dimensional and at least a further one may have a three-dimensional geometry to represent and/or approximate the room geometry.

In an example, reconstructing the room and/or approximating the at least part of the point cloud with a plurality of base elements may include selecting a plurality of base elements of same and/or different type, and calculating one or more spatial coordinates, and optionally further parameters for each base element, such that a number of data points or elements of the point cloud being arranged on or close to a surface of one or more of the base elements may be maximized. Accordingly, the one or more base elements may be fitted, e.g. based on adjusting one or more parameters of the one or more base elements, to points or elements of the point cloud, such that the sum or set of base elements forms an outer contour and/or surface that substantially or optimally resembles the geometry of the room. Hence by determining the base elements, the room geometry can be reliably and efficiently be computed and/or approximated. Also, approximating the room geometry with one or more base elements, which may have basic or simple geometry, may allow to reduce a data volume for further processing and hence can further speed-up the reconstruction process.

According to an embodiment, the geometry of the room is determined based on representing one or more boundaries of the room with the one or more base elements. For instance, at least a part of the point cloud that refers to or includes said one or more boundaries may be supplemented and/or replaced by one or more base elements in order to represent said one or more boundaries of the room by the one or more base elements.

According to an embodiment, representing the at least one portion of the point cloud with the one or more base elements includes substituting and/or replacing the at least one portion of the point cloud with the one or more base elements. Alternatively or additionally, representing the at least one portion of the point cloud includes retrieving one or more objects from a database, and substituting and/or replacing the at least one portion of the point cloud with the one or more objects retrieved from the database. For instance, one or more parametric models and/or other data associated with one or more objects can be retrieved from the database.

According to an embodiment, representing the at least one portion of the point cloud with the one or more base elements includes adjusting and/or altering a size of the one or more base elements. For instance, each of the base elements may correspond to, be associated with and/or include a parametric model of predefined geometry and/or shape with one or more paramterizable and/or adjustable parameters. Therein, the size of a base element may be adjusted and/or altered based on adjusting and/or altering the one or more parameters of the respective parametric model of the base element. Also one or more of an expansion and/or dimension of a base element in one or more spatial directions may be adjusted based on adjusting one or more parameters of the corresponding parametric model.

According to an embodiment, the method may further comprise adjusting a size, dimension, and/or expansion of the one or more base elements based on parameterizing the one or more base elements in accordance with a spatial arrangement of the least one portion of the point cloud to be represented by the one or more base elements.

According to an embodiment, representing the at least one portion of the point cloud with the one or more base elements includes determining one or more of a size, a position, and an orientation of the one or more base elements. In particular, one or more parameters of one or more parametric model associated with the one or more base elements may be determined, such that a number of points of the point cloud being arranged at or near a surface of the one or more base elements is maximized.

According to an embodiment, the method further comprises adjusting a size, dimension, and/or expansion of the one or more base elements based on parameterizing the one or more base elements in accordance with a spatial arrangement of the least one portion of the point cloud to be represented by the one or more base elements.

According to an embodiment, the geometry of the room is determined based on representing boundaries of the room with a spatial arrangement of a plurality of base elements. For instance, a plurality of base elements may be selected, adjusted in size, and arranged relative to each other to resemble the room geometry as indicated by the data points of the point cloud. Accordingly, the spatial arrangement of the base elements may refer to a composition or sum of the base elements having certain geometries and shapes and being arranged relative to one another, such that the surface and/or outer contour of the arrangement of base elements is preferably congruent with a maximum number of points of the point cloud.

Therein, the arrangement of base elements, the selected base elements, and/or the parameters of one or more parametric models of the base elements may be adapted or changed in an iterative process to identify the arrangement of base elements with the maximum number of points of the point cloud lying at or near the surface of the arrangement of base elements. Said arrangement of base elements may then be selected for further processing or modeling the interior room.

According to an embodiment, the method further comprises optimizing the spatial arrangement of the plurality of base elements based on minimizing a number of base elements utilized for representing all boundaries of the room. For instance, one or more base elements may be iteratively replaced and/or removed from a set of selected base elements to determine the spatial arrangement requiring a minimum number of base elements to accurately represent the one or more boundaries of the room. This may allow to further reduce a processing burden for subsequent tasks of modeling the interior room based on or using the spatial arrangement of base elements.

According to an embodiment, the point cloud is a three-dimensional point cloud, wherein the method further comprises generating a two-dimensional point cloud based on projecting the at least one portion of the three-dimensional point cloud onto a two-dimensional plane, preferably a horizontal two-dimensional plane through the at least part of the point cloud. For example, the method may comprise converting the three-dimensional point cloud into a two-dimensional point cloud. Alternatively or additionally, determining the geometry of the room may include generating and/or creating a two-dimensional projection of the at least one portion of the point cloud. Alternatively or additionally, a planar section or cross-section through a 3D point cloud may be used to generate a 2D point cloud. In particular, a plurality of projections of a 3D point cloud and/or a plurality of 2D point clouds may be generated.

A two-dimensional point-cloud projection or cross-section through a three-dimensional point cloud may particularly allow to determine the layout or floorplan of the room in the 2D plane defined by the 2D point cloud or the projection. Also, a plurality of 2D point cloud projections or cross-sections in planes having different heights above a ceiling, floor or other wall of the room may allow to determine and/or detect tilted boundaries, as well as a tilting angle of such boundaries of the room, as is for example the case with mansards or otherwise tilted walls or boundaries. Also curved and/or curvilinear sections of the room and/or one or more boundaries may be reliably determined based on one or more projections of the 3D point cloud into a 2D plane traversing the room.

According to an embodiment, the two-dimensional projection and/or cross-section of the point cloud is generated for a subset of the data points of the point cloud arranged in a layer of the point cloud. Therein, the layer may have a certain thickness or dimension, for example a predefined thickness or dimension in a direction parallel to surface normal vector of the layer, such that data points within this layer are projected onto the two-dimensional projection or plane. With decreasing thickness of the layer, the resulting projection increasingly approximates a cross-section through the 3D point cloud.

According to an embodiment, the method further comprises selecting an individual processing approach for processing the at least one portion of the point cloud, the individual processing approach being selected among the group consisting of processing of 3D point cloud data of the at least one portion of the point cloud, projection of the at least one portion of the point cloud into a single plane, and projection of the at least one portion of the point cloud into a plurality of planes.

According to an embodiment, the method further comprises rasterizing the two-dimensional projection of the at least one portion of the point cloud and/or the cross-section through the point cloud, thereby generating a two-dimensional grid approximating the point cloud, the cross-section and/or the projection of the point cloud. In other words, the two-dimensional cross-section and/or projection of the point cloud may be converted into a two-dimensional grid approximating the point cloud. Based on such grid, sizes, dimension, geometry and/or layout of the room may be determined with high accuracy and precision.

According to an embodiment, the method further comprises parameterizing one or more boundaries of the room based on raster-to-vector conversion using the two-dimensional grid, using image tracing, and/or and/or clustering with respect to orientation and location of the one or more boundaries. Also a plurality of two-dimensional grids, for example grids representing different planes through the point cloud and/or room at different distances from the ceiling, floor or another boundary, may be used to parametrize the one or more boundaries.

Generally, raster-to-vector conversion may include determining one or more vectors defining the one or more boundaries. Accordingly, the one or more two-dimensional grids may be converted into a set of one or more vectors defining the room geometry. This may allow to generate a realistic representation of the room and its geometry, which can further be processed and/or adjusted at minimum computing resources.

According to an embodiment, the method further comprises optimizing the parameterization of one or more boundaries of the room based on a segmentation approach and/or based on a segmentation resulting in one or more parametric models representative of the one or more boundaries. Such segmentation or segmentation approach resulting in one or more parametric models may also be referred to as parametric segmentation herein. Generally, such segmentation may be performed based on analyzing at least a part of a 3D or 2D point cloud using an artificial intelligence engine trained and/or configured for such purpose, as will be described hereinbelow in more detail.

According to an embodiment, the method further comprises optimizing the parameterization of one or more boundaries of the room based on an Active

Contours Model and/or based on Hough transform. Alternatively or additionally, a RANSAC (RANdomSAmpleConsesnus, RANSAC) approach or algorithm may be used to achieve a high degree of efficiency based on repeated random sampling.

According to an embodiment, the method further comprises determining a voxel representation and/or an occupancy map representation of at least a portion of the point cloud based on deep learning, in particular deep learning based on an occupancy network. For instance, the 3D or 2D point could may be analysed using a deep learning based occupancy network, which may provide as its output one or more occupancy maps and/or one or more voxel representations of at least a part of the point cloud, and hence at least a part of the interior room and/or one or more objects arranged therein. Therein, an occupancy map may refer to a probabilistic generalization of one or more binary voxels, i.e. a voxel having a binary value. Further, a voxel and/or binary voxel in a voxel representation (e.g. having a plurality of a binary voxels) may refer to a quantification of the probabilistic value of an associated item of the occupancy map. Accordingly, the room and/or one or more objects arranged therein may be reconstructed using a deep learning-based occupancy network generating an occupancy map and/or a voxel representation for the room and/or the one or more objects.

According to an embodiment, the method further comprises one or more of:
- removing one or more data points of the point cloud;
- adjusting and/or modifying a spatial position of one or more data points of the point cloud;
- removing one or more outliers from one or more regions of the point cloud;
- smoothing at least a subset of data points of the point cloud;
- combining a plurality of intermediate point clouds to generate the point cloud;
- filtering data points of the point cloud;
- interpolating data points of the point cloud; and
- extrapolating data points of the point cloud.

Any one or more of the aforementioned steps may be performed in order to further enhance an informational content of the point cloud. Also, points or data elements potentially adversely affecting the modeling or reconstruction of the room can be efficiently removed from the point cloud by applying one or more of the aforementioned steps. Alternatively or additionally, variations or differences in the sensor signals or point cloud data, for instance resulting from different sensor characteristics of different sensors, may be efficiently compensated for.

According to an embodiment, at least one of the one or more objects arranged in the interior room is associated with, refers to, includes and/or corresponds to an item of furniture arranged in the room. An item of furniture may either be fixedly installed (and hence also referred to as fixedly installed object herein), such as for example an oven, a sink, a bathtub, and a toilet, or an item of furniture may be movable and/or displaceable, such as for example a table, a couch, a bed, a chair and the like.

An object may be arranged in the interior room at a particular position (and/or location) and in a particular orientation. Therein, position and orientation of an object may also be referred to as pose of the respective object. Further, a position and/or location of an object may refer to and/or be given as one or more spatial coordinates of the object in a reference coordinate system related to the interior room, for example a coordinate system of the room. Further, an orientation of an object may be given relative to one or more reference points or spatial coordinates of the room, for example with respect to one or more reference points at one or more boundaries of the room.

In an exemplary embodiment, detecting the one or more objects arranged in the interior room comprises detecting one or more of a location, an orientation, and a type of the one or more objects. Therein, a type of an object may refer to a predefined or customizable, for example user-definable, classification of objects according to one or more predefined or customizable criteria descriptive of one or more features of the one or more objects. Such features may refer to functional features descriptive of a function of the object, to aesthetical features or features related to appearance of the object, or to features related to any other aspect of the object.

Exemplary types of objects may be fixedly installed objects, movable objects, items of furniture, items of daily use, decorative items, design items, items for seating, tables, items for sleeping, items of a particular color, items of particular shape, items related to work, or any other type or category descriptive of one or more features or attributes of an object.

According to an embodiment, the method further comprises segmenting the at least one portion of the point cloud using one or more segmentation algorithms, for example for detecting the one or more objects arranged in the room. As will be elucidated hereinbelow, one or more segmentation algorithms may be used for segmenting the at least part of the point cloud. It is emphasized that the at least part of the point cloud that is segmented may refer to a 2D or 3D point cloud.

In particular, it is noted that 2D segmentation may be applied, for example, on images, image data, rastered images, rendered images or any other 2D data. Alternatively or additionally, 3D segmentation can be performed on 3D point cloud data or any other 3D data. In an example, 2D images and/or image data can be segmented to generate 2D image labels that can be integrated and/or translated into the 3D point cloud for reconstructing the room.

According to an embodiment, the method further comprises generating segmented data based on or by segmenting one or more of the sensor data, the at least one image of the interior room indicated by the sensor data, further sensor data, and/or one or more further images of the interior room, for example one or more images containing one or more of RGB sensor data, multispectral sensor data, and/or depth sensor data. Therein, segmentation can be performed using one or more image segmentation algorithms, for example one or more algorithms based on semantic segmentation, instance segmentation and/or panoptic segmentation.

According to an embodiment, the method further comprises selecting and/or determining one or more algorithms, for example one or more algorithms for semantic segmentation, instance segmentation and/or panoptic segmentation. For example, the one or more algorithms may be selected based on one or more predefined criteria, e.g. associated with one or more of a type, amount, viewing angle, scale, resolution and quality of the data usable and/or available for segmentation.

By way of example, the generated segmented data may include one or more data elements indicative of one or more objects arranged in the room, one or more object features of one or more objects, one or more features of one or more boundaries of the room, one or more materials, colors, and/or textures of one or more boundaries and/or objects. Any one or more of such or other information contained in the segmented data or its data elements may be used or considered as label descriptive of one or more features or attributes of the room and/or one or more objects.

According to an embodiment, the method further comprises transforming, processing and/or converting the generated segmented data into the determined point cloud of the interior room.

For example, the transformation of segmented data into the point cloud can include selecting and/or weighting one or more data elements of the segmented data associated with one or more input images and/or other data used for segmentation. Selection and/or weighting may be done with respect to one or more parameters such as one or more of a type, amount, viewing angle, scale, resolution and quality of the data usable and/or available for segmentation. Alternatively or additionally, the transformation of segmented data into the point cloud can include mapping one or more data elements of the segmented data into the point cloud, for example based on extrinsic and intrinsic camera parameters. Alternatively or additionally, the transformation of segmented data into the point cloud can include post-processing of the segmented point cloud.

As used herein, segmentation may refer to or involve partitioning the point cloud, further sensor data, the sensor data, image data or other data into segments or regions associated with a subset of the respective data. Applying one or more segmentation algorithms may allow to reliably detect, locate and/or identify the one or more objects arranged in the room, one or more boundaries of the room or any other feature of interest contained in the processed data, such as the sensor data, the point cloud, further sensor data, image data or other data.

According to an embodiment, the at least one portion of the point cloud is segmented by means of semantic segmentation, instance segmentation and/or panoptic segmentation. Semantic segmentation may include determining a predefined class for each data element considered, for example for each point of the point cloud considered. This may allow to efficiently discern the objects in a room from a rest of the room. Instance segmentation may include identifying for each data element considered an associated instance of an object, which may allow to detect each distinct object as individual object. Panoptic segmentation may combine aspects of both semantic and instance segmentation.

According to an embodiment, the at least one portion of the point cloud is processed and/or segmented in two spatial dimensions. Alternatively or additionally, the at least one portion of the point cloud is processed and/or segmented in three spatial dimensions. Segmentation in two spatial dimensions may be particularly advantageous to detect a layout of the room and positions of the one or more objects in the room. Segmentation in three spatial dimensions may be particularly advantageous for detecting and/or determining a volume, geometry and/or shape of the interior room and/or the one or more objects.

According to an embodiment, the at least one portion of the point cloud is processed based on one or more of object detection, object retrieval, and/or pose estimation.

This can be performed, for example, on point cloud data and/or on 2D image data, e.g. rastered image data. Therein, object detection and/or pose estimation may be Al based. Object retrieval and/or pose estimation may involve browsing, searching and/or retrieving data associated with one or more objects arranged in the room or to be potentially arranged in the room from one or more databases. Further pose estimation may include estimating a position and orientation of an object.

According to an embodiment, the method further comprises detecting and/or identifying one or more objects arranged in the room based on the segmented at least one portion of the point cloud and/or based on generated segmented data. Therein detecting the one or more objects may include detecting one or more of location, orientation, and pose of the respective object. Also one or more further characteristics of an object may be detected, such as material, function, and/or type of the object.

As used herein, a material of a boundary of the room, such as a wall of the room, a ceiling of the room, a floor of the room, and/or a material of one or more objects may include one or more properties descriptive of an optical appearance and/or usable for visually representing the boundary and/or object. In particular, a material of a boundary of the room and/or a material of one or more objects may include a reflectance and/or texture of the corresponding element or its surface. Therein, reflectance may optionally be related to and/or indicative of a color of the corresponding boundary and/or object or its surface. Any reference herein to a texture and/or a color of a boundary of the room, such as a wall of the room, a ceiling of the room, a floor of the room, and/or of one or more objects includes a reference to the corresponding material.

According to an embodiment, the method further comprises associating the detected one or more objects with one or more reference objects indicative of one or more reference items of furniture. Therein, the detected one or more objects may include one or more of an item of furniture, wherein based on the detected type of the object one or more reference items of furniture corresponding to the detected one or more objects may be identified, for example in a database.

According to an embodiment, the detected one or more objects are associated with one or more reference objects based on image retrieval and/or point cloud retrieval utilizing a database storing a plurality of reference objects (or corresponding data) indicative of a plurality of reference items of furniture. For instance, for each detected object in the room a corresponding reference object may be searched and/or identified, for example in a database at the server, based on one or more features and/or characteristics descriptive of the detected object.

According to an embodiment, the detected one or more objects are associated with the one or more reference objects based on deep learning. For example, a deep learning-based AI engine at the server may be trained and/or configured to identify one or more reference objects based on image data, sensor data, point cloud data, segmented data or any other data indicative of one or more characteristics or features of the object considered.

According to an embodiment, the method further comprises retrieving, from a database storing a plurality of reference objects (or corresponding data) one or more parametric models for and/or representative of the detected one or more objects. Generally, a parametric model may be representative of the respective reference object and may be parametrizable based on adjusting and/or altering one or more parameters of the parametric model. Such adjustable parameters may for example refer to parameters for adjusting one or more of size, shape, geometry, material, color, texture or any other characteristic or feature of the (reference) object or its parametric model.

According to an embodiment, the method further comprises adjusting one or more parameters of the retrieved one or more parametric models, such that each of the parametric models corresponds in one or more of shape, geometry, color, material, texture and/or size to the corresponding detected one or more objects arranged in the room. Accordingly, the detected one or more objects may be simulated and/or resembled by the one or more adjusted parametric models.

According to an embodiment, detecting the one or more objects comprises detecting one or more reference points of the of the one or more objects, wherein the one or more parameters of the retrieved one or more parametric models are adjusted based on the detected one or more reference points of the one or more objects.

Therein, the one or more reference points may refer to spatial coordinates of the detected one or more objects. By way of example, a reference point may be a discernable point or section of the considered object, such as an edge, a corner, a center, or any other suitable reference point.

According to an embodiment, the method further comprises replacing and/or substituting one or more of the detected objects by one or more other objects, for example similar objects. Therein, the "other or similar objects" may be provided in the form of one or more parametric models, as described hereinabove and hereinbelow. It is emphasized that a similarity between objects is not limited to aesthetical features or characteristics of objects, but can refer to any feature, function, characteristic and/or attribute of the objects. Hence, similar objects may denote objects substantially matching and/or fitting each other with respect to one or more features, functions, characteristics and/or attributes of the objects under consideration.

According to an embodiment, the method further comprises determining a mesh representation and/or voxel representation for one or more of the detected objects. In particular, a voxel representation and/or mesh representation may be computed as an alternative or in addition to object retrieval for reconstructing the one or more objects.

According to an embodiment, the method further comprises determining one or more materials, textures and/or colors of at least a part of a boundary of the room, in particular a material, a texture and/or color of one or more of a wall, a ceiling, and a floor of the room, based on processing the point cloud, sensor data and/or one or more images indicative of at least a part of the room and/or the one or more objects arranged therein.

As used herein, determining the material, and/or the texture may include determining one or more of a material composition, a material, a surface quality, a finishing, a surface coating, a haptic, a roughness, and a surface topology of a floor, a ceiling and/or one or more walls of the room.

According to an embodiment, the one or more materials, textures and/or colors of the one or more boundaries of the room are determined using machine learning and/or deep learning. Machine or deep learning algorithms may be particularly suitable for detecting material, texture and/or color, as many different textures and/or colors can be pre-trained and thus detected reliably and efficiently, in particular based on or using 2D image data for detecting materials, textures and/or colors.

According to an embodiment, the method further comprises determining, based on processing the point cloud, sensor data and/or one or more images indicative of at least a part of the room and/or the one or more objects arranged therein, one or more materials, textures and/or colors of the one or more objects arranged in the room. Any disclosure presented hereinabove with respect to determining a material, texture and/or color of a boundary of the room equally applies to determining a material, texture and/or color of the one or more objects. For instance, the one or more materials, textures and/or colors of the one or more objects arranged in the room may be determined using machine learning and/or deep learning.

According to an embodiment, the method further comprises retrieving, from a database storing a plurality of reference materials and/or textures of reference room boundaries and/or reference objects, material data and/or texture data resembling the determined one or more materials and/or textures of one or more boundaries of the room and/or of one or more objects arranged therein.

Alternatively or additionally, the method may further comprise retrieving, from a database storing a plurality of reference colors of reference room boundaries and/or reference objects, color data resembling the determined one or more colors of one or more boundaries of the room and/or of one or more objects arranged therein. By retrieving material and/or texture data and/or color data, the room may be reconstructed and/or modelled in a realistic manner.

According to an embodiment, the method further comprises detecting and/or identifying one or more light sources arranged in the room, arranged outside the room and/or illuminating the room. This may, for example, include determining one or more of position, location, orientation, color, intensity, illumination direction, and shading of the one or more light sources.

Optionally, the method may further comprise determining a lighting condition in the room based on the detected one or more light sources. Therein, the lighting condition may be indicative of one or more of position, location, orientation, color, intensity, illumination direction, and shading of the one or more light sources. Generally, by considering the lighting condition in the room and/or one or more light sources, the room and/or the objects arranged therein may be modelled and/or reconstructed realistically, which may include a mood or atmosphere in the room.

According to an embodiment, the method further comprises generating a virtual scene of the room.

In the context of the present disclosure a virtual scene may refer to or denote a composition and/or collection of scene data, for example including one or more parametric models representative of the room, and one or more parametric models for the detected one or more objects. Optionally, also material data, texture data, color data or any other data indicative and/or descriptive of one or more features, characteristics and/or attributes of the room and/or the one or more objects may be included in the virtual scene and/or the corresponding scene data. Further, it is noted that a virtual scene and/or the scene data composing the scene may optionally be displayed at a user interface, for example a user interface of the user device, thereby generating a virtual representation and/or visualization of the virtual scene.

According to an embodiment, the method further comprises compiling, gathering and/or collecting, at the server, scene data based on the reconstructed room and the one or more detected objects arranged therein. As noted above, the scene data may include a collection and/or composition of one or more parametric models representative of the room, one or more parametric models for the detected one or more objects, texture data, material data, color data and/or any other data indicative and/or descriptive of one or more features, characteristics and/or attributes of the room and/or the one or more objects.

According to an embodiment, the scene data includes data indicative of a parametric model of one or more boundaries of the room using one or more base elements. Further, the scene data may optionally include data indicative one or more parametric models for the detected one or more objects arranged in the room and/or for one or more further objects to be placed into the room or virtual scene.

According to an embodiment, the one or more parametric models are retrieved from a database storing a plurality of reference objects indicative of a plurality of reference items of furniture. It is noted that any disclosure presented hereinabove and hereinbelow with reference to retrieving one or more parametric models representative of one or more boundaries of the room, as may for example be applied for reconstructing the room geometry, equally applies to the one or more parametric models retrieved from a database for one or more objects.

According to an embodiment, the scene data further includes material data, and/or texture data indicative of one or more materials and/or textures of at least a part of a boundary of the room, in particular at least one of a wall, a ceiling, and a floor of the room. Alternatively or additionally, the scene data may further include color data indicative of one or more colors of at least a part of a boundary of the room, in particular at least one of a wall, a ceiling, and a floor of the room.

According to an embodiment, the scene data further includes material data and/or texture data indicative one or more materials and/or textures of the one or more detected objects arranged in the room. Alternatively or additionally, the scene data may further include color data indicative one or more colors of the one or more detected objects arranged in the room. Alternatively or additionally, the scene data may further include lighting data indicative one or more light sources arranged in the room, arranged outside the room and/or illuminating the room. Alternatively or additionally, the scene data may include data indicative of a lighting condition, a mood, a design, a tone, and/or an atmosphere of at least a part of the room. It is noted that any one or more of the aforementioned data elements of the scene data may be determined in the course of reconstructing and/or modeling the room and/or one or more objects, as described in more detail hereinabove and hereinbelow.

According to an embodiment, the method further comprises transmitting at least a part of the scene data from the server to the user device, and visualizing the received at least part of the scene data at a user interface of the user device in a three-dimensional and/or two-dimensional virtual representation of the scene. Accordingly, the scene data may be displayed at the user interface in a graphical representation of the room, one or more objects arranged therein, and optionally other features of the scene, for instance one or more materials, textures, colors, light sources, or the like.

According to an embodiment, the method further comprises adapting and/or modifying the at least part of the scene based on altering a viewing angle and/or a viewing position at the user interface of the user device. For example, a user input from the user device may be received at the server, wherein the at least part of the scene is altered and/or modified in response to and/or based on the received user input. It is noted that rendering can be done at the server or at the user device.

As used herein, altering or modifying the scene may comprise altering and/or modifying of one or more data elements of the scene data, from which the scene may be composed. For instance, one or more parametric models of one or more boundaries of the room, one or more parametric models of one or more objects arranged in the room, material data and/or texture data related to one or more boundaries/objects, color data related to one or more boundaries/objects, data related to the lighting condition or to one or more light sources, or other data elements of the scene or scene data may be altered and/or modified. This can include replacement, substitution, addition and/or removal of one or more of the aforementioned data elements of the scene data. In other words, the method may further comprise altering, adding, modifying, replacing, removing and/or exchanging one or more objects in the at least part of the scene based on altering, adding, modifying, replacing, removing and/or exchanging one or more data elements of the scene data representative of the one or more objects.

According to an embodiment, the one or more objects visualized in the at least part of the scene are altered, added, modified, replaced, removed and/or exchanged automatically and/or based on one or more user inputs. For instance, a user may select one or more objects displayed at the user device and provide a user input requesting a recommendation for modification of the selected object. Alternatively or additionally, one or more of the objects contained in the scene or scene data may be automatically altered, added, modified, replaced, removed and/or exchanged by the server, for example based on one or more user settings or based on other criteria, as also further described hereinbelow.

According to an embodiment, the method further comprises altering and/or modifying a geometry of at least a part of the room visualized in the virtual representation of the scene in response to receiving a user input from the user device at the server. This may include re-computation, adaption, modification, and/or re-parametrization of one or more parametric models of the room previously determined, or computation of one or more new parametric models for the room in response to the user input.

According to an embodiment, altering and/or modifying a geometry of at least a part of the room visualized in the virtual representation of the scene includes providing a top view, a cross-sectional view and/or a bird's eye view of at least a part of the room in the visualized scene. For instance, a polygonal representation of the at least part of the room may be included in one or more of the aforementioned views, the polygonal representation being modifiable based on a user interaction at the user interface of the user device.

According to an embodiment, the user interaction at the user interface includes selecting one or more reference points of the polygonal representation and displacing the selected one or more reference points. Accordingly, the user may be enabled to intuitively adapt or modify the scene according to its preferences.

For example, a user may modify a geometry of the room, e.g. by displacing one or more reference points, e.g. corners, of the room or corresponding polygonal representation at the user interface, and the server may compute a new or modified parametric model for the modified geometry of the room, in particular a parametric model representative of a 3D geometry of the room.

According to an embodiment, the user interaction at the user interface includes inserting one or more reference points into and/or removing one or more reference points from the polygonal representation of the at least part of the room. Also such modification may allow to intuitively modify the room geometry.

According to an embodiment, the method further comprises receiving, at the server from the user device one or more numerical inputs associated with one or more boundaries of the room and/or one or more objects visualized in the room. For instance, one or more numerical measures for dimensions and/or lengths of one or more boundaries of the room may be provided as user input. Optionally, also other numerical or non-numerical inputs may be defined or provided by the user for the one or more boundaries of the room and/or one or more objects. Exemplary and non-limiting inputs may relate to one or more of material, texture, color, lighting condition, mood, atmosphere, design, function of an object, type of an object, or the like.

According to an embodiment, the method further comprises providing at least one recommendation for a modification of said at least one object, for example one or more detected objects, based on modifying the parametric model. Therein, the recommendation may include determining and/or computing the recommendation at the server based on the detected object. Optionally, the recommendation may be provided from the server to the user device, for example by transmitting corresponding data or a corresponding signal indicative of the recommendation to the user device.

According to an embodiment, the method further comprises providing, from the server at the user device, one or more recommendations for a modification of the one or more objects, e.g. one or more of the detected objects, in at least a part of the generated scene. Alternatively or additionally, the method may comprise providing, from the server at the user device, one or more recommendations for a modification of one or more boundaries of the room in at least a part of the generated scene.

According to an embodiment, the one or more recommendations include one or more of a recommendation for replacement of at least one of the one or more objects, a recommendation for a material modification of at least one boundary of the room, a recommendation for a material modification of one or more objects, a recommendation for a texture modification of at least one the one or more objects, a recommendation for a texture modification of at least one boundary of the room, a recommendation for a positional change of one or more objects, a recommendation for a geometrical change of at least a part of the room, a recommendation for a geometrical change of one or more of the objects, a recommendation of a color change of one or more objects, a recommendation of a color change of one or more boundaries of the room, a recommendation for a modification of one or more light source, and a recommendation for a change of a lighting condition.

Generally, a recommendation may be transmitted from the server to the user device and instruct the user device to notify the recommendation to the user. For instance, a message may be displayed, the modified and/or altered element may be displayed for selection or confirmation by the user, or the modified and/or altered element may be integrated in the scene displayed at the user device. Optionally, modified, updated and/or altered scene data may be transmitted along with a recommendation or may be included in a recommendation. Also a plurality of recommendations may be provided at the user device, for example in the form of a list, or the like.

According to an embodiment, the method further comprises determining, at the server, one or more recommendations for the modification of the one or more objects in the at least part of the generated scene. Alternatively or additionally, the method may comprise determining, at the server, one or more recommendations for the modification of one or more boundaries of the room in the at least part of the generated scene.

According to an embodiment, the method may further comprise determining, at the server, one or more recommendations for the insertion and/or addition of one or more further objects into the at least part of the generated scene.

In an exemplary implementation, the one or more recommendations for the insertion and/or addition of the one or more further objects are determined based on one or more predefined placement constraints for the at least part of the generated scene. In particular, an available or free space in the interior room may be computed and the one or more further objects or corresponding recommendations may be computed and/or determined taking into consideration the computed free or available space. For instance, a distance between two objects, an object and a boundary, and/or between two boundaries of the room may be computed to determine one or more recommendations for the insertion of one or more further objects.

According to an embodiment, the one or more recommendations for modification of one or more boundaries of the room and/or one or more objects are determined by the server based on one or more predefined and/or user-definable criteria. In a non-limiting and exemplary implementation, the one or more predefined and/or user-definable criteria may be associated with one or more of an interior design of at least a part of the room, a color scheme of at least a part of the room, a design of one or more objects, a color of one or more objects, a material of one or more objects, a material of one or more boundaries, a texture of one or more objects, a texture of one or more boundaries of the room, a lighting condition in the room, a type of one or more objects, a function of one or more objects, a size of one or more objects, a size of an empty space in the room, a number of objects located in the room, a functional relationship between a plurality of objects, a distance between objects, and a distance of one or more objects to one or more boundaries of the room. This may enable the user to modify, alter and/or optimize the room or scene according to its wishes, demands, and preferences.

For example, a user may define that certain objects or certain types of objects should preferably be located close to each other to minimize a walking distance between the objects, and the server may compute an optimum scene or room layout, e.g. with one or more parametric models for the room and/or one or more objects arranged therein, under consideration or taking into account the userdefined criterion. Such implementation may be particularly advantageous in professional environments like offices, facilities, labs, or hospitals, in order to optimize the working environment or "room" in terms of minimizing walking distance between certain objects in the room, and/or certain areas, regions or parts of the room.

In another example, a criterion related to a function of an object may be defined, which may allow to optimize the layout or composition of the room in accordance therewith. For example, a user may define that certain objects having a certain function or certain types of objects, e.g. objects related to items of sleeping, eating, washing, or other activity, should be arranged and/or placed in the room according to one or more criteria, such as a criterion for maximizing a distance between objects due to their associated function, minimizing a distance between objects due to their associated function, or selecting a distance between objects of certain function according to a numerical value or other user input provided by the user.

According to an embodiment, a recommendation for modifying one or more boundaries and/or one or more objects includes object data of one or more recommendation objects associated with one or more boundaries of the room, one or more walls, a floor, a ceiling, one or more items of furniture, one or more doors and/or one or more windows being recommended as candidate for replacing, supplementing, removing inserting and/or modifying the generated scene, e.g. modifying one or more of the objects in the scene.

According to an embodiment, the one or more recommendations are determined by the server based on a similarity metric descriptive of a measure of similarity for one or more object features. Therein, the one or more object features may be defined for the same or different objects.

As used herein, the measure of similarity may refer to and/or denote a measure of fit for the one or more object features. Generally, the measure of fit and/or the measure of similarity, and hence the corresponding metric, may reflect and/or correlate with a level or degree of similarity (or dissimilarity) for the one or more object features considered. Accordingly, "the similarity metric of a measure of similarity" may also be referred to herein as "metric of a measure of fit"

It is emphasized that a similarity between objects is not limited to aesthetical features or characteristics of objects, but can refer to any feature, function, characteristic and/or attribute of one or more objects. Hence, similar objects may denote objects substantially matching and/or fitting each other with respect to one or more features, functions, characteristics and/or attributes of the objects.

According to an embodiment, a plurality of recommendation objects for modification, addition, insertion, removal, substitution, and/or replacement of a single object of the scene, for example an object contained in the generated scene data, is determined by the server. The method may further comprise determining a measure of similarity for each recommendation object based on the similarity metric, and ranking the plurality of determined recommendation objects based on the determined measures of similarities.

According to an embodiment, the method further comprises evaluating one or more objects, for example one or more pairs of objects, of the scene and/or contained in the scene data against one or more recommendation objects based on determining the measure of similarity applying the similarity metric.

According to an embodiment, the measure of similarity is determined using a deep learning algorithm and/or one or more pretrained neural networks.

In an exemplary embodiment, the method further comprises obtaining a feature vector for a set of objects in the scene based on aggregating individual feature vectors of individual objects, and evaluating a set of objects of the scene against a set of recommendation objects based on the obtained feature vector and based on determining a similarity measure and/or measure of fit.

For aggregation, various approaches can be applied, including Bag-of-words clustering, multiple-instance learning and basic parameters, such as mean and standard deviation on feature level, can be computed. Alternatively or additionally, methods dedicated to collaborative filtering, including autoencoders can be used to reconstruct e.g. a missing item of furniture and/or object, based on a set of objects, wherein a feature representation for each individual item and/or object may be used. For that purpose, a pretrained convolutional neural network can be used.

For training models providing a measure of fit and/or similarity based on more than one items of furniture and/or objects, images showing fully equipped rooms (e.g. in combination with object detection) can be used as well as data from other users for example applying collaborative filtering.

For example, a feature vector may define and/or encode one or more features of an object. Such feature may be included, contained and/or encoded in a latent representation of the object, for example in the form of sensor data of one or more image sensors, further sensor data of one or more further sensors, point cloud data, or any other data descriptive of the object and/or the one or more features considered. In other words, a latent representation of an object can be encoded in any one or more of the aforementioned 2D and/or 3D data.

Alternatively or additionally, a feature considered may refer to one or more definable object features, for example based on user input or other information provided. For instance, text information, image information (e.g. in form of a mood board) and/or other data in structured or non-structured form can be included in and/or used as an input for a deep learning algorithm and/or one or more neural networks, either alone or in addition to a latent representation, e.g. in the form of sensor data of one or more image sensors, further sensor data of one or more further sensors, point cloud data, or any other data descriptive of the object and/or the one or more features considered. Generally, this can allow to tailor and adapt the overall process of modeling the room according to any feature of interest, for example of interest to the user. As a consequence, a room or scene under consideration may be optimized according to any user-definable preference or pre-criterion reflected in the one or more features of the one or more objects considered.

According to an embodiment, the measure of similarity is determined based on a deep learning algorithm minimizing a feature distance of matching objects and/or maximizing a feature distance of mis-matching objects. Therein, the deep learning algorithm may receive as an input any data descriptive of the object and/or the one or more features considered.

In an exemplary and non-limiting implementation, the measure of similarity may be determined using a Siamese convolutional neural network consisting of a plurality of convolutional networks having shared weights descriptive of one or more object features in a latent representation of the one or more object features.

For example, the Siamese convolutional neural network may utilize or apply the same weights in two or more convolutional neural networks while processing in parallel two or more different input vectors, e.g. feature vectors, to compute comparable output vectors based on applying the similarity metric descriptive of the measure of similarity for one or more object features considered. Therein, the similarity metric may be pre-trained or may be adapted or modified, for example based on re-training the Siamese convolutional neural network.

According to an embodiment, the measure of similarity is determined based on a classification algorithm and/or a regression algorithm. Such classification algorithm and/or a regression algorithm may be applied as an alternative or in addition to the aforementioned deep learning approach using a Siamese convolutional neural network.

For example, based on or using one or more convolutional neural networks, one or more features of one or more objects can be considered, estimated and/or predicted in the form of a categorical or continuous variable. Any feature of interest can in principle be considered, wherein a data set may be provided for each object type, which may contain for each object feature considered a binary or continuous scalar variable that reflects the ground truth.

According to an embodiment, the measure of similarity is determined based on one or more user inputs defining one or more object features. For instance, the user input may define text information and/or image data (e.g. in form of mood boards) other data in structured or non-structured form, which can be included in and/or used as an input for a deep learning algorithm and/or one or more neural networks, either alone or in addition to a latent representation, e.g. in the form of sensor data of one or more image sensors, further sensor data of one or more further sensors, point cloud data, or any other data descriptive of the object and/or the one or more features considered.

For example, a user may provide in addition to the sensor data, point cloud data and/or other data one or more user inputs as unstructured text and/or image data or structured data from a user query. Text can optionally be converted into structured form. It is also conceivable that different controls are provided at the user device to simplify user input. For example, input could also be provided via selection of a mood board at the user device.

Generally, a representation of an object and/or one or more object features considered can differ for humans and computing systems. Accordingly, a representation for a user encoding one or more object features for one or more objects, for example based on a user input at a user device, may be transformed into a form that is processible by the one or more computing devices involved, such as the user device and one or more servers. Hence, parameterization and/or adaption of the one or more features by the user based on providing one or more user inputs can be enabled.

It is noted that different representations do not necessarily have to be well-defined, but can be ambiguous. For example, there may be several different representations, e.g. for mood boards, reflected in a single computer-based representation, or vice versa.

According to an embodiment, providing the one or more recommendations includes retrieving product data from one or more e-commerce servers related to one or more recommendation objects. For example, the retrieved product data may include one or more of image data, model data, textural data, structural data, functional data, color data, product specification data, and design data associated with the one or more recommendations and/or one or more recommendation objects.

In an Al based implementation for providing the one or more recommendations, for example, product data from one or more e-commerce servers and/or other training data may be used to generate targeted, optimal recommendations and/or sequences, lists or collections of recommendations for one or more n objects. Optionally, any interaction with the user and/or user-device, for example one or more user inputs received as request to modify a scene of a room displayed at the user device, may be used to generate annotated training data in order to optimize the process of generating and/or providing one or more recommendations iteratively through operational use, as described hereinbelow.

According to an embodiment, the method further comprises receiving, at the server from the user device, user feedback related to one or more recommendations and/or related to one or more recommendation objects associated with one or more recommendations provided, computed and/or generated by the server.

According to an embodiment, the method further comprises generating training data using the user feedback related to the one or more recommendations and/or recommendation objects provided by the server. Alternatively or additionally, the method may further comprise annotating training data using the user feedback related to the one or more recommendations and/or recommendation objects provided by the server.

According to an embodiment, the method further comprises collecting and/or receiving one or more user inputs for adapting and/or modifying at least a part of the scene, at least a part of the room, and/or one or more objects of the scene. Therein, the scene may refer to a set of scene data that may optionally be visualized at the user device. Further, the one or more user inputs may be used to generate the training data.

In an exemplary embodiment, the received one or more user inputs that are used for generating the training data are indicative of one or more of an erroneous placement of an object within the visualized scene, a modification requested by the user for one or more objects visualized in the scene, a user request for placement of an additional object into the visualized scene, a user request for placement of an alternative object into the visualized scene, a user request for modification of an object visualized in the scene, a user request for a rearrangement of one or more objects in the visualized scene, a user request for a geometrical change of one or more objects in the visualized scene, and a user request for a geometrical change of at least a part of the visualized room. Any one or more of the aforementioned user inputs can be used to generate new training data and/or annotate existing training data.

For instance, scene data of a particular scene may be modified by the user based on one or more user inputs, and the modified scene data may be used as training data. Alternatively or additionally, the one or more user-inputs may be used to annotate the training data to generate annotated training data. Also any other data indicative of the user feedback may be used as training data, alone or in addition to other training data.

According to an embodiment, the method further comprises supplying the generated training data, annotated training data, scene data, modified scene data, and/or a user-feedback to a data pool for training one or more artificial intelligence based, Al-based, modules. For instance, the Al-based engine may be iteratively improved or optimized based on the feedback provided by the user and/or gathered from the user, thereby allowing to provide a versatile system providing a high level of customer experience.

According to an embodiment, the method further comprises training the one or more Al-based modules for reconstructing a further room, for reconstructing one or more objects, for image or point cloud retrieval, for visualizing a reconstructed room, for visualizing a reconstructed scene, for visualizing one or more reconstructed objects, for segmentation, for object detection, for object recognition, and/or for providing one or more recommendations to a user. Accordingly, the training data can be used to improve any one or more of the aforementioned functionalities implemented in one or more computing devices to improve the overall process of modeling an interior room.

According to an embodiment, the method further comprises generating and/or computing synthetic training data descriptive of one or more representations of at least one interior room with one or more objects arranged therein.

As used herein, synthetic training data may refer to or denote a set of training data which may only contain computer-generated data. This does not exclude, however, that the synthetic training data are at least partly computed based on or derived from "real" data, such as sensor data captured with one or more image sensors.

Further, a representation of at least one interior room may refer to or denote a collection of data elements or data set descriptive of one or more features of the interior room and/or one or more objects arranged therein. For example, a representation may include data or data elements corresponding to one or more of scene data, sensor data, further sensor data, data related to user-input or feedback, or any other data, for example as described hereinabove.

According to an embodiment, generating the synthetic training data includes providing, computing and/or generating one or more parametric models for and/or representative of the interior room, each parametric model being adjustable in one or more parameters associated with one or more of an angle between two boundaries of the interior room, a number of boundaries of the interior room, a geometrical shape of the interior room, a floor plan of the interior room, a layout of the room, and one or more dimensions of one or more boundaries of the interior room.

The one or more parametric models may be generated solely in a computational approach or they may be generated based on and/or derived from sensor data of one or more image sensors of a user device and based on reconstructing the room, as described hereinabove. For example, scene data generated for a user and the one or more parametric models for the room and/or one or more objects arranged therein may be used as a starting point to generate synthetic training data.

According to an embodiment, the method further comprises varying parameters of the parametric models provided for the interior room, thereby generating a plurality of representations of the interior room. By varying parameters of the parametric models, entirely new or modified scenes, corresponding scene data and/or rooms may be created and included in the synthetic training data. Generally, this may allow to cover the entire range of the parameters that may reflect a range of variation or variability of the corresponding parameter(s) in real data or real-world data, such as (real) sensor data of one or more image sensors. In turn, using such synthetic training data or collection of synthetic training data for training an Al-based engine can allow to reliably detect trained features in any scene, set-up or configuration reflected in the synthetic training data. Accordingly, any possible scenario or scene can be generated and included in the synthetic training data, without requiring real-world data for every scenario or scene. Hence, efforts associated with the training process can be minimized while maximizing efficiency, performance and versatility of the trained Al-based engine.

According to an embodiment, the method further comprises obtaining a distribution of realistic parameters for the parametric models from one or more real scenes. As used herein, realistic parameters may refer to realistic parameter values for one or more parametric models generated and/or computed based on or using sensor data from one or more image sensors. For example, a range of variability and/or variance of the parameter values of one or more parameters of parametric models determined based on sensor data may be estimated and/or computed. For instance, based on analysing and/or comparing the parameter values computed based on different sensor data and/or different rooms, the distribution of realistic parameters or parameter values may be determined.

According to an embodiment, the method further comprises placing one or more objects, in particular one or more fixedly installed objects, one or more doors, and/or one or more windows, into each of the plurality of representations of the interior room.

As used herein, placing an object may include incorporating or including said object in a data set descriptive of the corresponding representation of the interior room. Merely optionally, a representation or the corresponding data set may be visualized at a display or user interface, e.g. at the server or user device or other computing device used for generating the synthetic training data.

In an example, placing an object in a representation can include determining and/or computing one or more of size, geometry, shape, location, position, pose, material, texture, color, type, function, attribute and/or any other feature descriptive of an object. The corresponding computed one or more values may be included, for example as parameter values for one or more parametric models, in the one or more representations to generate the synthetic training data.

According to an embodiment, one or more of a number, a positional arrangement, a dimension, an orientation, a design, a type, a size, a geometry, a shape, a color of one or more objects, and a distance between neighboring objects is varied among the plurality of representations of the interior room.

Accordingly, the one or more parameters or parameter values of one or more parametric models of the interior room considered for generating the synthetic training data may be varied based on applying one or more of the aforementioned operations to compute one or more further data sets for one or more representations of the room. Such further data sets or any other data set associated with a representation of the interior room can, alone or in combination, constitute, be comprised in and/or be used as synthetic training data.

According to an embodiment, the one or more objects are representative of at least one door and/or at least one window arranged at a boundary of the interior room.

According to an embodiment, the method further comprises retrieving model data descriptive of one or more doors and/or windows from a database. For example, a database may be maintained at a server and/or one or more other computing devices, which database may include data indicative and/or descriptive of one or more features of one or more objects, for example as described hereinabove with respect to object retrieval from a database based on "reference objects" stored therein. Therein, the model data can include any data descriptive of one or more features of one or more objects under consideration, such as sensor data of real image sensors, computed or simulated sensor data, further sensor data of any other type of sensor, image data, textual data, and/or data related to any one or more of function, type, attribute, material, texture, and color of one or more objects.

According to an embodiment, corresponding or matching doors and/or windows are placed into a single representation of the interior room. For instance, matching and/or similar doors and/or windows may be determined based on applying a similarity metric indicative of a measure of similarity, as described in more detail hereinabove and hereinbelow.

According to an embodiment, the method further comprises defining one or more material attributes and/or texture attributes for one or more boundaries of the interior room, preferably for one or more walls, a ceiling, and a floor of the interior room, and associating the one or more material attributes and/or texture attributes with one or more representations of the interior room. Optionally, the material attributes (also referred to herein as "material") and/or the texture attributes (also referred to as "texture" herein) can be varied among the plurality of representations of the interior room. Accordingly, a collection of varying or different material attributes and/or texture attributes may be computed and mapped and/or linked to different representations to generate the synthetic training data. Hence, a broad spectrum of realistic scenes or scenarios for one or more rooms, i.e. for the same or for different rooms, may be computed and covered in the set of representations and/or the synthetic training data.

Also, computation and generation of representations covering a realistic range of variation of one or more parameters can be computed at low computational cost and at minimized manual input or effort required, as is often the case when training data is generated based on labelling or annotation performed by humans. In addition, gathering real data for any possible scene or scenario may only hardly be achievable within reasonable time, whereas generating synthetic training data as proposed herein allows to quickly adapt the synthetic training data and train or-retrain one or more corresponding Al-based engines on one or more computing devices.

According to an embodiment, the method further comprises placing one or more further objects into each of the plurality of representations of the interior room, the one or more further objects being associated with an item of furniture, an item of daily use and/or an item of decoration. Any item related or non-related to interior design could be included in one or more representations to generate the synthetic training data.

In an exemplary embodiment one or more of a number, a positional arrangement, a dimension, an orientation, a design, a type, a size, a geometry, a shape of one or more further objects, and a distance between neighboring further objects is varied among the plurality of representations of the interior room.

According to an embodiment, the method further comprises retrieving model data descriptive of the one or more further objects from a database. As discussed above, any data descriptive of one or more features of one or more objects can be included in the model data, such as sensor data, simulated sensor data, further sensor data, point cloud data, image data, textual data, or any other data.

According to an embodiment, the one or more further objects are varied among the plurality of representations of the interior room. This can include varying one or more of position, location, pose, orientation, type, color, material, texture and/or any other feature associated with one or more objects. For instance, the one or more further objects can be randomly placed into each representation of the interior room, randomly varying one or more of the aforementioned parameters.

According to an embodiment, the one or more further objects are placed into each representation of the interior room according to a predefined heuristic. For example, the similarity metric described herein may be applied as predefined heuristic. Alternatively or additionally, any metric and/or parameter descriptive of or related to one or more features of one or more (further) objects can be used for placing the one or more further objects into one or more representations based on computing corresponding values or data for generating the synthetic training data.

According to an embodiment, the method further comprises arranging one or more light sources within each representation of the room, preferably wherein a number, characteristic and/or position of the light sources positioned in different representations of the interior room are varied among the plurality of representations of the interior room. Similar to the "placement of an object" into a representation, "arranging a light source" may include computing one or more values or data associated with one or more of position, size, location, material, texture, color, or any other feature related to a light source.

According to an embodiment, the method further comprises simulating an environment of the interior room based on projecting geographical content into one or more windows placed into one or more representations of the interior room, preferably wherein the projected geographical content is varied among the plurality of representations of the interior room. Also such implementation may allow to include realistic and versatile representations in the synthetic training data, which may cover a broad spectrum or range of real scenes or scenarios. Alternatively or additionally, content may be projected into one or more reflecting surfaces, such as mirrors, or the like.

According to an embodiment, the method further comprises rendering each of the representations of the interior room at a plurality of viewing positions and/or viewing angles to generate a plurality of image frames and/or image data usable as training data for training the Al-based module. For example, each image frame can include or contain one or more RGB images, one or multispectral images, one or more depth maps, one or more semantic segmentation labels, one or more instance segmentation labels, one or more intrinsic and/or extrinsic camera parameters, ground truth scene mesh, and/or sampled point cloud data from a scene mesh.

In an example, the plurality of viewing positions and/or viewing angles can be randomly selected. Alternatively or additionally, the plurality of viewing positions and/or viewing angles can be selected according to a predefined heuristic, for example a heuristic resembling movement of a user through the interior room. Hence, realistic representations or collections of representations of one or more rooms may be generated and included in the synthetic training data, which may mimic and/or simulate a user capturing and/or acquiring sensor data, for example one or more images, to model and/or reconstruct a room, as described hereinabove and hereinbelow.

According to an embodiment, the method further comprises computing one or more trajectories, in particular one or more trajectories learned from real trajectories, resembling movement of a user through the room.

According to an embodiment, the method further comprises computing sensor data of an image sensor corresponding to one or more rendered image frames. Computing sensor data may include simulating a sensor, for example a sensor hard- and/or software, to generate sensor data. Accordingly, synthetically generated and/or computed sensor data may be included in the synthetic training data. Also, variations between different types of sensors, different characteristics of sensors, or the like can be considered in the synthetic training data.

According to an embodiment, the method further comprises computing at least a part of a point cloud corresponding to one or more of the rendered image frames. Similar to the computation of sensor data, also synthetically generating and/or computing point cloud data may allow to reflect expected variations in the determination of the point cloud, for example due to different sensor characteristics of image sensors, in the synthetic training data.

According to an embodiment, the generated synthetic training data is usable for one or more of learning-based 2D segmentation of RGB sensor data, learning-based 2D segmentation of multispectral and/or RGB sensor data (with or without depth data), learning-based estimation of depth data based on RGB and/or multispectral data, learning-based optimization (and/or super-resolution) of depth data based on RGB and/or multispectral data, learning-based 3D segmentation of a point cloud, learning-based 3D reconstruction, learning-based scan completion, learning-based 2D-to-3D reconstruction based on multiple images, learning-based 2D-to-3D conversion based on single images, and learning-based image retrieval.

According to an embodiment, the method further comprises supplementing the generated synthetic training data with manually and/or semi-automatically generated training data descriptive of one or more real configurations of one or more real interior rooms.

According to an embodiment, the method further comprises supplementing and/or annotating the generated synthetic training data with one or more user inputs and/or user feedback received from the user device.

According to an embodiment, the method further comprises optimizing a degree of realism of rendered scenes using generative adversarial networks in combination with real data.

These and other aspects of the disclosure will be apparent from and elucidated with reference to the appended figures, which may represent exemplary embodiments.

### Brief Description of the Drawings

The subject-matter of the present disclosure will be explained in more detail in the following with reference to exemplary embodiments which are illustrated in the attached drawings, wherein:
Fig. 1 shows a computing system for modeling and/or reconstructing an interior room according to an exemplary embodiment;
Fig. 2 shows a flowchart illustrating steps of a method of modeling an interior room according to an exemplary embodiment;
Figs. 3 to 5 each show a flowchart illustrating steps of a method of reconstructing an interior room according to exemplary embodiments;
Fig. 6 shows a flowchart illustrating steps of a method of generating synthetic training data according to an exemplary embodiment; and
Figs. 7A to 7C illustrate steps of one or more methods according to one or more exemplary embodiments.

The figures are schematic only and not true to scale. In principle, identical or like parts are provided with identical or like reference symbols in the figures.

### Detailed Description of Exemplary Embodiments

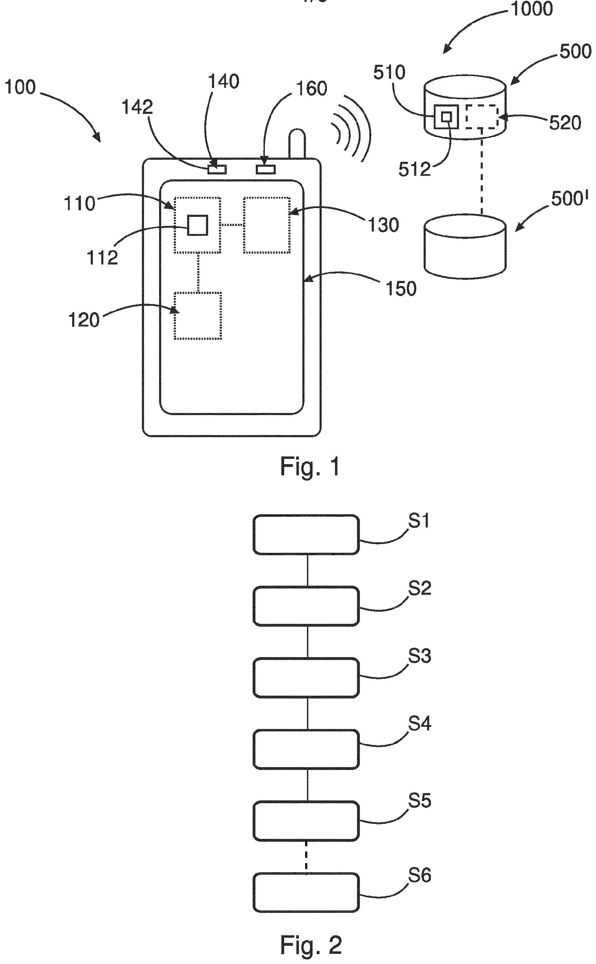

Figure 1 shows a computing system 1000 for modeling and/or reconstructing an interior room according to an exemplary embodiment. The computing system 1000 of Figure 1 can particularly be configured to carry steps of any one or more of the methods according to any one or more aspects of the present disclosure, for example as described with reference to any of Figures 2 to 7C.

The computing system 1000 comprises a user device 100 with a processing circuitry 110 and one or more processors 112 for data processing.

The user device 100 further includes a data storage 120, for example for storing software or computer instructions instructing the user device 100 to perform one or more steps, operations or functions, as described herein.

The user device 100 of Figure 1 exemplary illustrated as smartphone or mobile device. The present disclosure, however, is not limited in this respect.

The user device 100 further comprises a user interface 150 for displaying data and/or receiving one or more user inputs from a user of the user device 100.

The user device 140 further comprises at least one image sensor 140 configured to acquire sensor data indicative of one or more images of a surrounding or environment of the user device 100. The image sensor 140 may be part of a camera 142 and/or other means for acquiring one or more images and/or corresponding sensor data. The at least one image sensor 140 may refer to or include any one or more of an RGB sensor, a multispectral sensor, or other type of image sensor.

It is emphasized that in the context of the present disclosure, sensor data may refer to or be understood as raw sensor data or sensor signals, which can be directly acquired with the one or more image sensors 140. An image or corresponding image data, for example pixel data, may be derived from such sensor data, and for example further rendered to provide a rendered image frame.

The user device 100 optionally comprises one or more further sensors 160, such as a LIDAR senor, a gyroscope, an accelerometer, an acoustic sensor, a depth sensor, a stereo camera, or any other sensor 160, which may be configured to acquire further sensor data that may optionally be used for modeling and/or reconstructing an interior room.

The sensor data of the at least one image sensor 140 and/or the further sensor data of the at least one further sensor 160 may optionally be stored in the data storage 120.

Moreover, the user device 100 includes a communication circuitry 150 for communicatively coupling the user device 100 to one or more servers 500, 500' of the computing system 1000. The communication circuitry 150 of the user device 100 may be configured for wired and/or wireless communication with one or more other computing devices, as exemplary indicated by the servers 500, 500' in Figure 1.

In particular, Figure 1 schematically shows a server 500 with a processing circuitry 510 and one or more processors 512 for data processing. The server 500 is particularly configured to receive sensor data, point cloud data and/or other data from the user device 100 for modeling and/or reconstructing an interior room.

The server 500 may refer to a plurality of computing devices, for example a plurality of interoperating servers 500 of a cloud computing network.

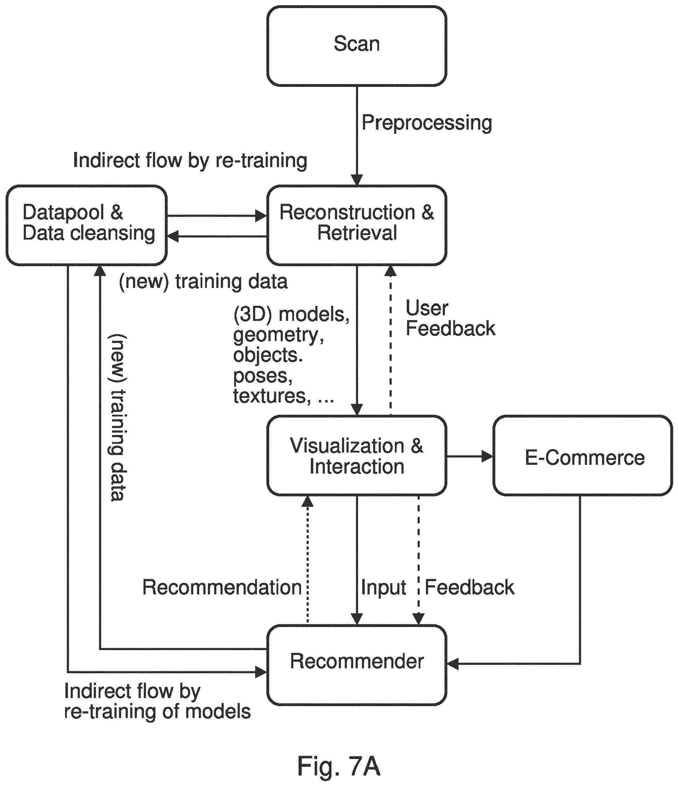

Further, server 500 may include one or more modules, engines and/or dedicated functional blocks 520 for performing one or more dedicated tasks or operations in the process of modeling and/or reconstructing the interior room, as exemplary described with reference to Figures 7A to 7C. In particular, one or more Al-based engines, modules, algorithms and/or circuitries 520 may be implemented in hard- and/or software for performing one or more of the operations and functionalities described herein.

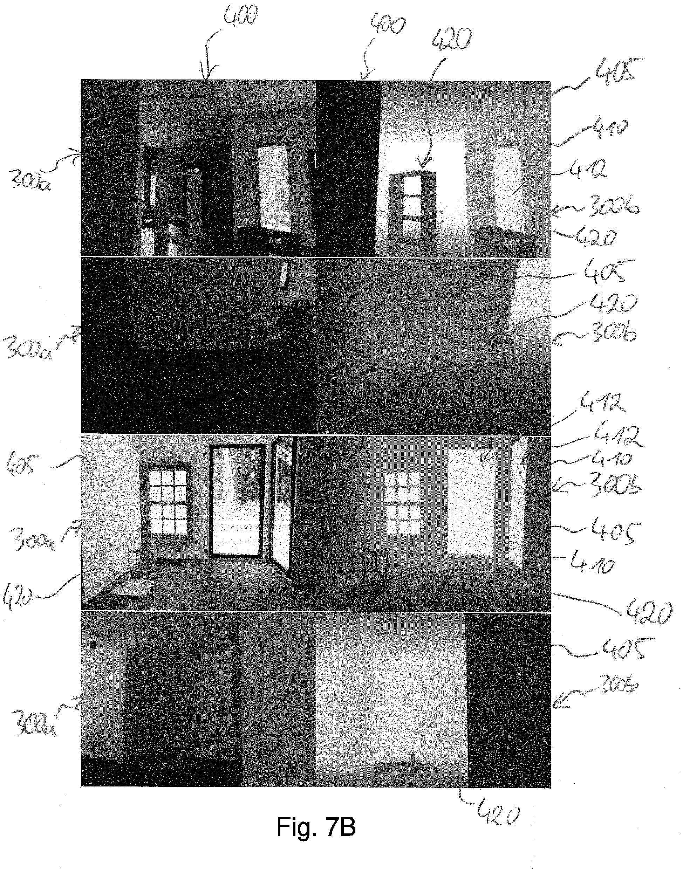

For example, the server 500 may include one or more dedicated blocks, modules and/or engines 520 for reconstruction of a room (400, see Fig. 7B) and/or one or more objects (410, 420, see Fig. 7B). Alternatively or additionally, the server 500 may include one or more dedicated blocks, modules and/or engines 520 for retrieval of data from a database for reconstruction and/or visualization and/or modeling of a room. Alternatively or additionally, the server 500 may include one or more dedicated blocks, modules and/or engines 520 for generating synthetic training data, for visualization of data at the user device 100 and/or for interaction with a user, as exemplary described with reference to Figures 7A to 7C.

Moreover, server 500 and/or user device 100 may be communicatively coupled with an e-commerce platform or server 500' for obtaining data related to one or more objects therefrom, as exemplary described with reference to Figures 7A to 7C.

Figure 2 shows a flowchart illustrating steps of a computer-implemented method of modeling an interior room according to an exemplary embodiment, for example using the computing system 1000 of Figure 1.

At step S1, sensor data may be received at the user device 100 and/or at the server 500. This may include acquiring and/or capturing the senor data using the at least one image sensor 140 of the user device 100. Alternatively or additionally, receiving the sensor data in step S1 may include transmitting the sensor data to the server 500.

Step S2 comprises determining, based on the sensor data at the server 500 and/or at the user device 100, at least a part of a point cloud representative of the at least part of the room (400, see Fig. 7B) and/or representative of one or more objects (410, 420, see Fig. 7B) arranged in the room. Therein, the point cloud may be determined and/or computed at the user device 100 and transmitted to the server 500, and/or it may be determined at the server 500.

Step S3 comprises reconstructing at least a part of the room based on the determined point cloud. Also parts of the reconstruction process of the room may be performed at the user device 100 and/or at the server 500.

Step S4 comprises detecting the one or more objects arranged in the room based on the determined point cloud. Also parts of step S4 may be performed at the user device 100 and/or at the server 500.

In a further step S5, a virtual scene is generated based on the reconstructed at least part of the room and the detected one or more objects, wherein the virtual scene includes a parametric model representative of one or more boundaries of the room and at least one parametric model representative of at least one of the detected one or more objects arranged in the room. Therein, the virtual scene may be provided in the form of scene data by the server 500.

Optionally, the virtual scene may be displayed at the user device 100, e.g. upon receipt of the scene data from the server 500.

In an optional step S6, at least one recommendation for a modification of said at least one object may be provided based on modifying the parametric model.

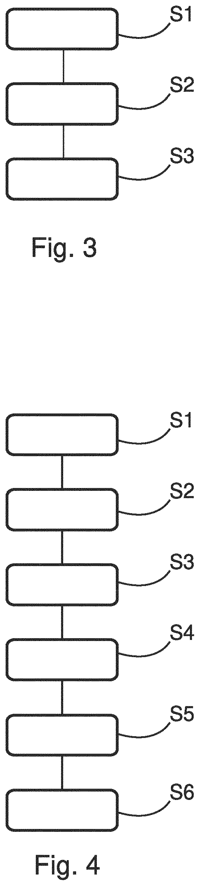

Figure 3 shows a flowchart illustrating steps of a computer-implemented method of reconstructing an interior room according to an exemplary embodiment, for example using the computing system 1000 of Figure 1. Unless stated otherwise, the method illustrated in Figure 3 may include and/or may be combined with any one or more of the steps of the method illustrated in Figure 2.

At step S1, sensor data may be received at the user device 100 and/or at the server 500. This may include acquiring and/or capturing the senor data using the at least one image sensor 140 of the user device 100. Alternatively or additionally, receiving the sensor data in step S1 may include transmitting the sensor data to the server 500.

Step S2 comprises determining, based on the sensor data at the server 500 and/or at the user device 100, at least a part of a point cloud representative of the at least part of the room and/or representative of one or more objects arranged in the room. Therein, the point cloud may be determined and/or computed at the user device 100 and transmitted to the server 500, and/or it may be determined at the server 500.

Step S3 comprises reconstructing at least a part of a geometry of the room based on representing at least a portion of the point cloud with one or more base elements associated with one or more parametric models of predefined geometry and/or shape. Also parts of the reconstruction process of the room may be performed at the user device 100 and/or at the server 500.

Figure 4 shows a flowchart illustrating steps of a computer-implemented method of reconstructing an interior room according to an exemplary embodiment, for example using the computing system 100 of Figure 1. Unless stated otherwise, the method illustrated in Figure 4 may include and/or may be combined with any one or more of the steps of the methods illustrated in Figures 2 and 3.

At step S1, sensor data may be received at the user device 100 and/or at the server 500. This may include acquiring and/or capturing the senor data using the at least one image sensor 140 of the user device 100. Alternatively or additionally, receiving the sensor data in step S1 may include transmitting the sensor data to the server 500.

Step S2 comprises determining, based on the sensor data at the server 500 and/or at the user device 100, at least a part of a point cloud representative of the at least part of the room and/or representative of one or more objects arranged in the room, wherein at least one of the one or more objects is associated with a door, with a window, and/or with an item of furniture arranged in the room. Therein, the point cloud may be determined and/or computed at the user device 100 and transmitted to the server 500, and/or it may be determined at the server 500.

At step S3, one or more objects are detected based on the determined point cloud, for example at the user device 100 and/or at the server 500. Step S3 may include determining one or more of a location, an orientation, and a type of the one or more objects arranged in the room.

In step S4, the detected one or more objects are associated with one or more reference objects indicative of one or more reference items of furniture, reference doors, and/or reference windows. Also step S4 may be performed at the user device 100 and/or at the server 500.

Step S5 comprises determining one or more parametric models for the detected one or more objects.

Step S6 comprises reconstructing at least a part of the room based on the determined one or more parametric models for the detected one or more objects.

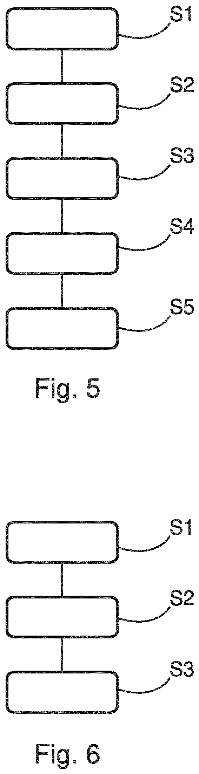

Figure 5 shows a flowchart illustrating steps of a computer-implemented method of reconstructing an interior room according to an exemplary embodiment, for example using the computing system 1000 of Figure 1. Unless stated otherwise, the method illustrated in Figure 5 may include and/or may be combined with any one or more of the steps of the methods illustrated in Figures 2 to 4.

At step S1, sensor data may be received at the user device 100 and/or at the server 500. This may include acquiring and/or capturing the senor data using the at least one image sensor 140 of the user device 100. Alternatively or additionally, receiving the sensor data in step S1 may include transmitting the sensor data to the server 500.

Step S2 comprises determining, based on the sensor data at the server 500 and/or at the user device 100, at least a part of a point cloud representative of the at least part of the room and/or representative of one or more objects arranged in the room.

Therein, the point cloud may be determined and/or computed at the user device 100 and transmitted to the server 500, and/or it may be determined at the server 500.

At step S3, one or more objects are detected based on the determined point cloud, for example at the user device 100 and/or at the server 500. Step S3 may include determining one or more of a location, an orientation, and a type of the one or more objects arranged in the room.

Step S4 comprises generating, based on the one or more detected objects, scene data for a virtual scene representing the room. Also step S4 may be performed at the user device 100 and/or at the server 500.

Step S5 comprises determining one or more recommendations for a modification of the one or more objects in the generated scene data. Also step S5 may be performed at the user device 100 and/or at the server 500.

Figure 6 shows a flowchart illustrating steps of a computer-implemented method of generating synthetic training data according to an exemplary embodiment, for example using the computing system 1000 of Figure 1. Unless stated otherwise, the method illustrated in Figure 6 may include and/or may be combined with any one or more of the steps of the methods illustrated in Figures 2 to 5.

Step S1 comprises providing and/or generating one or more parametric models for and/or representative of the interior room, each parametric model being adjustable in one or more parameters associated with one or more of an angle between two boundaries of the interior room, a number of boundaries of the interior room, a geometrical shape of the interior room, a floor plan of the interior room, and one or more dimensions of one or more boundaries of the interior room.

Step S2 comprises varying parameters of the parametric models provided for the interior room, thereby generating a plurality of representations of one or more interior rooms

Step S3 comprises generating synthetic training data usable for training an Al module, the synthetic training data being descriptive of at least a subset of the generated representations of the one or more interior rooms.

Figures 7A to 7C illustrate steps of one or more methods according to one or more exemplary embodiments, for example using the computing system 1000 of Figure 1. Unless stated otherwise, the method illustrated in any of Figures 7A to 7C may include and/or may be combined with any one or more of the steps of the methods illustrated in Figures 2 to 6.

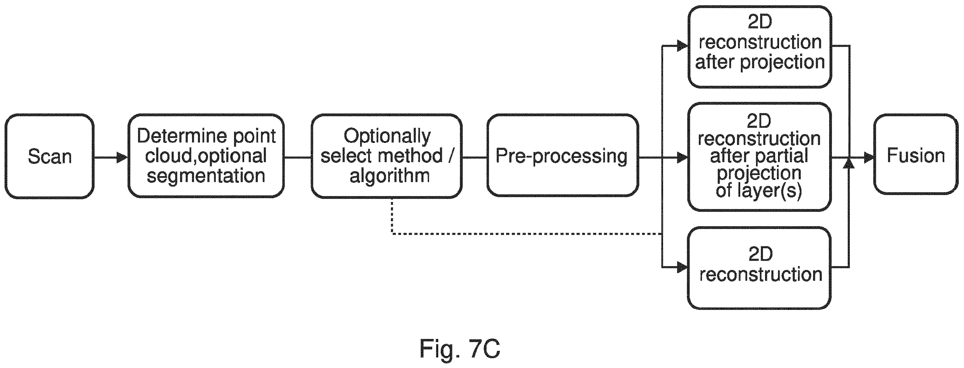

In particular, Figure 7A shows a flow chart illustrating one or more functional blocks and/or modules 520 of a system 1000 of modeling an interior room 400. Figure 7B illustrates exemplary data generated and/or used in the process of modeling and/or reconstructing an interior room 400. Figure 7C shows a flow chart of one or more aspects of modeling and/or reconstructing an interior room 400.

In the following, one or more exemplary and non-limiting implementations of one or more aspects and exemplary embodiments for modeling and/or reconstructing an interior room 400 and/or for generating training data or synthetic training data are described. It may be referred to in the following to any one or more of Figures 1 to Figure 7C.

In summary, the computing system 1000 may be configured to acquire sensor data taken from a scan of an interior room 400 with a user device 100. The system 100 may further be configured to reconstruct the room 400 and/or one or more objects 410, 420 arranged therein, for example based on object retrieval. The system 1000 may further be configured to visualize the reconstructed room 400, e.g. at the user device 100, and allow for an interaction of the user via the user interface 150. Optionally, a connection to one or more e-commerce platforms 500, 500' may be provided. Generally, data may be transmitted between any of the entities involved. In particular, data may be transmitted from the user device 100 to the server(s) 500, 500', and vice versa.

The system 1000 may further provide a strategy for an efficient generation and use of training data, for example to provide product recommendations for furnishing objects 420, 410 or items and/or design elements or items (e.g. furniture, lamps, pictures, colors), which may optionally be referred to as assets herein. Relevant for the generation and/or computation of one or more recommendations may be one or more features, attributes and/or properties of the interior room 400 and/or one or more objects 410, 420 arranged therein, such as geometry and style, as well as user-definable preferences and/or criteria, such as type, use, size, style, or price of an object, for example an item of furniture.

As for example illustrated in Figure 7A and 7C, a user may scan at least a part of a room 400 based on acquiring one or more images 300a of the room 400. Exemplary images 300a are shown on the left side in Figure 7B, wherein one or more steps of reconstructing the room 400 are illustrated on right side of Figure 7B and referred to collectively with reference numeral 300b.

For scanning the room 400, one or more image sensors 140 and/or other sensors 160 of the user device 100 may be used. For example, RGB sensors, depth sensors and/or multispectral sensors may be used.

Further, the room 400 and/or one or more objects 410, 420 may be reconstructed. In Figure 7B, the room 400 comprises one or more boundaries 405, such as one or more walls a floor and a ceiling. Further, one or more fixedly installed objects 410, such as one or more windows and/or doors 410, may be arranged in one or more of the boundaries 405. Moreover, one or more further objects 420, such as items of furniture, like a chair or cupboard, may be arranged in the room 400. In the process of reconstructing the room 400 and/or one or more objects 410, 420 arranged therein, one or more parametrizable and/or parametric models of the room, of one or more boundaries 405 of the room 400 and/or of one or more objects 410, 420 may be computed and/or determined. One or more of such parametric models may be visualized, as exemplary illustrated by reference numeral 412 in Figure 7B which illustrates a parametric model of windows and/or doors 420, which can be displayed e.g. at a display of a server 500 and/or the user device 100.

Through interaction with the user and based on the reconstructed one or more parametric models, the user can influence, modify and/or adjust the further behavior of the system 100, for example in order to provide one or more recommendations according to one or more user-definable criteria, such criteria regarding function, type or style or other aspects of one or more objects 410, 420.

A recommendation engine or recommender 520 implemented at the server 500 may further use a connection to an e-commerce platform 500', as well as other training data, to generate targeted, optimal recommendations, or sequences of recommendations. The interaction with the user can automatically generate a feedback loop. Therein, knowledge gained from the interaction can flow back into the system 1000 in the form of new annotated training data in order to optimize it iteratively through operational use.

The overall system 100 envisaged herein can provide numerous benefits and advantages. For example, suitable and requirement-specific product recommendations may be provided to the user. Further, an optimal trade-off effort-benefit may be achieved for the user. Also, simplified data acquisition, simplified input for the user, intuitive interaction, efficient use of resources through high user satisfaction, and furnishings that are used over the long term can be provided for the user. On the business side, the possibility for increased transparency, reduced barrier to market entry for small companies, efficient marketing opportunity without own business branches, optimal customer satisfaction, and the possibility of individual production and adaptation of furnishings based on virtual models may be provided. In addition, optimal use of resources may be guaranteed due to long service life, and CO₂ emissions may be further reduced through online purchasing, e.g. of one or more objects 410, 420 recommended by the system 1000.

In the following details and possible implementations of possible components, modules and/or devices involved are described. For scanning the room 400, sensor data is acquired with the user device 100. Data acquisition may be performed independently by the user with minimal guidance. By means of the user device 100 and its integrated sensors 140, 160, the user may record color and/or depth information (and potentially gyroscope or other data) of the room 400 in the form of sensor data and/or further sensor data indicative of one or more images 300a or other features of the room 400. The user may walk through the room 400 while carrying the user device 100 in front of him. The way of recording may have influence on the quality of the generated raw data or sensor data. The speed of movements, for example, may affect the number of generated points of depth sensors as well as motion blur of color signals or sensor data. Furthermore, the extent of shadowing by objects 410, 420 can be minimized by more precise recording some parts of the room 400, e.g. by panning, moving up and down the user device 100. Such shadowing may adversely affect the quality of reconstruction, since missing data points may only be interpolated to a limited extent. Generally, movements may be harder to track than pure rotations of the user device 100, which can potentially affect the reconstructed and/or determined point cloud. Finally, the distance between the device 100 and objects 410, 420 may have an impact on the behavior of the algorithms used for reconstructing the room 400. For example, the point cloud reconstruction can suffer from too small distances between sensor 140 and object 410, 420, since no key points on homogeneous surfaces may reliably be detected. Furthermore, there may be a maximum and/or a minimum distance from the device 100 below/above which no reliable data can be acquired or delivered.

To make data acquisition as user-friendly as possible, the user may receive immediate feedback and/or instructions related to the scanning progress. In addition, he may be notified if the movement is too fast, or in the case that unfavorable distances (too close, too far) to objects 410, 420 are selected. Potential shadowing may also be pointed out to the user.

After the scan is complete, the raw data or sensor data may be transferred to the reconstruction entity, such as for example the server 500. For the purpose of more effective processing, data pre-processing can be performed at the user device 100 and/or at the server 500, for example before the actual reconstruction. For instance, the sensor data may be normalized in one or more pre-processing steps. For example, the number of points in the point cloud may be automatically adjusted. Likewise, the sensor signal or data, e.g. RGB sensor, multispectral sensor and/or depth sensor data, can be adjusted in terms of resolution and/or intensity. Likewise, noise reduction and/or blur compensation can be applied.

In the following, exemplary aspects and possible implementations of data cleaning and the generation of a data pool are described. Training data may be relevant to train the data-driven processes. For instance, a combination of synthetically generated training data, manually and/or semi-automatically annotated real data, automatically collected data and/or data obtained from the operational process can be used. Conceivably, one or more of these data sources may be empty.

Training data for segmentation and reconstruction may, on the one hand, be provided in the form of synthetic training data that can be used as data for segmentation and reconstruction. For this purpose, models of 3D interior spaces or rooms can be automatically generated based on adjustable constraints and/or criteria, and rendered for training. Thus, 3D point clouds and 2D sensor data as well as depth maps may be generated. Also manually annotated 2D images, image data and/or corresponding sensor data as well as 3D point cloud data can be used.

Finally, training data may be extracted and validated from the operational process. For example, user feedback may be gathered and/or obtained to annotate, correct and/or modify training data.

For the recommender or recommendation engine 520, training data manually annotated data as well as data that is collected automatically can be used as training data. For example, it is conceivable that freely available online data with metadata is collected via platforms. Photos of combinations of interior rooms can serve as training data base for learning-based methods. The evaluation (ground truth) can likewise be obtained automatically (for example, by evaluating photos or from meta-data) or generated manually. Finally, information obtained from operations can be fed directly back into the system 1000. Selections that have been positively evaluated by the user can be included as positive examples. Rejected recommendations can be included as negative examples.

The aforementioned sources of possible training data and their communication or flow between various components or modules of the overall system 1000 are illustrated in Figure 7C and annotated accordingly.

In the following, exemplary aspects and possible implementations of the generation of synthetic training data are described. To train the 3D reconstruction and retrieval methods, in the first instance synthetic training data may be used. This may allow easy scaling of the training data, simple and flexible adaptation to new needs (e.g. different segmentation necessary, use of the application in other cultures, issues with special room geometries/furniture/colors/textures/materials, issues in the case of reflective surfaces). For the training of deep learning architectures, almost any amount of data material including ground truth (ground truth, label, annotation) can be generated by means of rendering methods. The following applications, for example, can be addressed with it. 2D segmentation of single RGB or RGB+Depth sensor data. Semantic segmentation with convolutional neural networks (such as U-Net, ResNet), as is instance segmentation with convolutional neural networks (such as Mask RCNN). Further, 3D segmentation of point clouds (semantic and instance segmentation), learning-based 3D reconstruction, e.g., using a Convolutional-Occupance Network), learning-based scan completion, learning-based 2D to 3D reconstruction based on single RGB or RGB+Depth or sensor data with an output as a voxel grid, learning-based 2D to 3D conversion based on single RGB or RGB+Depth frames or sensor data with an output as a parametric 3D scene, and learning-based image retrieval with and without pose estimation can be trained based on the approach described herein.

Relevant aspects for the generation of synthetic training data may be the realism of the data. For example, the synthetic data models should be similar to real data in the areas of imaging properties (e.g., sensor noise, color features), spatial relations of objects, object properties or features (e.g., geometry, texture, material), and light propagation. Further, the training data should be variable and preferably cover the spectrum of the expected real data, parameters and/or values as closely as possible. It may in certain cases not be sufficient to generate realistic data, but the distribution of all parameters or values within the data should be similar to that of the real data

For generating synthetic training data, geometric and/or parametric models of rooms may be automatically generated, where angles, number of walls and wall lengths as well as room heights may be variable and the distribution of these parameters may be selectable and parameterizable. Discrete as well as continuous distributions can be combined.

Further, windows and/or doors 410 may be inserted, whereby the number in each case may be variable, or the underlying distribution can be parameterized. Minimum distances between windows and windows as well as windows and doors, doors and doors and windows/doors and room corners can be defined. Also the number can be related to the size (e.g. m²) of the rooms. Parametric models for doors and windows can be selected from a database. This is done either randomly distributed or with predefined probabilities. In order to create consistent rooms, the same parametric models may optionally be used with one or more differing parameters for each room.

Further, one or more materials and/or textures (or material/texture attributes) for floor, walls and ceilings and/or boundaries 405 of the room 400 may be defined. The selection may be based on random selection, whereby for each boundary 405 (floor, wall, ceilings) there may be separate databases in which the materials and/or textures can be defined. Here it is also optionally possible to define the probability of each material and/or texture. The textures can optionally be varied in their color or reflectance.

Further, items of furniture or furnishing objects 420 (e.g. table, chair, TV, lamps) can be inserted into the one or more representations of the one or more rooms 400. For each room type, the distribution of the number of different objects 410, 420 and object groups can be defined. For example, a group of seats can be grouped as object groups, and individual objects of the group can be defined randomly.

The placement of objects 410, 420 may be completely random or in compliance with a predefined heuristic (e.g. TV near the couch). Also, minimum distances of objects 410, 420 and object groups can be defined.

Further, one or more additional objects 410, 420 can be optionally inserted, such as pens, paper, glasses, plates, cutlery, vases, smartphones, tablets, notebooks, balls, glasses, upholstery, pictures, sockets, light switches, desk lamp. For each type of item there may be a database of parametric models. For each type of object 410, 420 it may be possible to define on which other object 410, 420 they are placed (e.g. notebook on table, poster on couch). Also a number of instances of each type per room 400 or a distribution over this number can be defined.

Finally, the outside world/environment surrounding the room 400 can optionally be selected from a database, e.g. randomly. This may allow a wide variety of geographic image content to be projected into windows, for example urban western city or rural South American environment, or the like. In addition, the external lighting conditions can be randomly selected (equally distributed, or from a specific distribution). Likewise, the internal lighting conditions can be variable among various representation generated for the synthetic training data.

In the following, exemplary aspects and possible implementations related to rendering using the synthetic training data are described. Individual frames can be rendered from one or more representations generated for one or more rooms 400.

This can be done either uniformly distributed, randomly with random position and/or random view angle, and/or based on a heuristic to imitate the movement of a user with a user device 100 through a room 400. In the latter case, for example, the height (position z-axis) can be simulated as the eye height of humans using a normal distribution. Beyond single frames, it may also be possible to generate motion trajectories based on which frames can be rendered at specific intervals.

The sensor properties of the simulation model applied may be customizable. Conceivable are simple RGB sensors, stereo RGB cameras, dual pixel cameras or RGB cameras combined with depth sensors (e.g. LiDAR), multispectral sensors or other sensors.

Any combination of data can be used for training an Al-based engine or module 520 at the server 500, such as 3D model data of one or more parametric models, one or more rendered frames, 3D point cloud data generated using motion trajectories, 3D or 2D point cloud data, 2D segmentation data, 3D segmentation of point clouds, and 3D voxel representation of the parametric models.

In the following, exemplary aspects and possible implementations related to reconstruction and retrieval are described, which is particularly illustrated in Figure 7C. The reconstruction and retrieval described herein may provide an efficient, parameterizable and manipulable scene that can represent reality as accurately as possible (geometrically and visually). For this purpose, different methods can be used or applied, alone or in combination.

For instance, pre-processing may be applied. For example, a 3D point cloud may be generated from the input data, such as sensor data, individual RGB frames with or without depth information. This can take place either on the user device 100 and/or at the server 500 or cloud. Furthermore, various forms of normalization can be applied, for example, to normalize the sensor characteristics. Also, it may be possible that, for example, non-existent depth maps are generated synthetically from other sensor data, e.g. RGB or multispectral sensor data, using deep learning methods. The same applies to other sensor data, such as gyroscope data.

For the reconstruction of a room or room geometry, one or more base elements 412 that may be parameterizable elements of predefined geometry and/or shape, such as planes, cylindrical surfaces, spherical surfaces, conical surfaces or others can be used to represent boundaries 405 of the interior room 400 by means of a few simple elements. Likewise, processing in a 2D projection (for example, top view) can be performed, wherein 2D base elements 412 may be used such as straight lines, circles and ellipses. In special cases it can be useful not to perform a complete projection, but a projection of layers with a certain thickness. This can be useful when "horizontally sloping" walls, such as mansards, are to be reconstructed, for example.

By optimally choosing the base elements 412, the point cloud can be accurately represented using a small number of base elements 412. For this optimization, potentially different methods can be used.

For example, a method can be used that first projects a predefined region onto 2D coordinates of the x-y plane (where the x-y plane represents the horizontal plane, i.e., the normal vector of the plane is vertical). The resulting 2D point cloud may be rasterized in the next step so that 2D image processing techniques can be used. Further, based on the resulting image, a method can be used to represent the boundaries 405 of the room 400 in a parameterized way. This step can be performed, for example, using image tracing (raster-to-vector conversion) techniques. Further, the resulting parameterization or one or more corresponding parametric model can be optimized using energy minimization techniques. Alternatively or additionally, parametric segmentation methods like Active Contours models can be used or the Hough Transformation method may be applied.

Furthermore, the RANSAC method can be used to achieve a higher degree of efficiency based on repeated random sampling. Finally, deep learning-based methods that generate a voxel representation can be used, e.g. using a deep learning-based Occupancy Network, which can convert a point cloud into an implicit representation from which a voxel representation can be generated. This method can likewise serve as a precursor to the conventional methods described (RANSAC, Hough, Image Tracing, Active Contours). By using deep learning methods, unwanted artifacts can be removed. The resulting voxel grid can also be projected into two dimensions.

Furthermore, conventional (i.e. non-learning based) pre-processing methods can be applied optionally. Examples are outlier removal on point clouds, morphological operations or smoothing in gridded data. The choice of method can either be predefined or based on properties of the input data. Furthermore, a parallel calculation using several methods can be performed in order to finally select the best one. This can concern the complete scene as well as parts of the scene.

For object reconstruction and detection a similar or different approach compared to room reconstruction may be applied. While rooms can be reconstructed as a sum of base elements 412, objects 410, 420, e.g. items of furniture, windows and/or doors, may further be matched with a database in order to find parametric models that are as similar as possible. For this purpose, one or more image and/or point cloud retrieval methods can be applied, however, also deep learning-based methods can be applied.

If adequate objects or recommendation objects cannot be found in the database, they may be replaced by similar ones, or alternatively not replaced. In the latter case, it is possible to represent the objects 410, 420 by means of meshes or voxels.

For segmentation, 2D and/or 3D segmentation methods can be used to semantically segment the interior room 400, one or more boundaries 405 and/or one or more objects 410, 420 (e.g. furniture, lamps, walls, windows, doors). In the case of 2D segmentation, convolutional neural networks can be used. For 3D segmentation, point cloud based deep learning methods may be used (e.g. PointNet, PointNet++, Jsis3D, Graph-CNNs).

For material and/or texture recognition of the texture and/or material of the room, one or more boundaries 405 and/or one or more objects 410, 420 (e.g. walls, ceilings, floors), corresponding images 300a (one or more) can be used to find similar textures and/or materials using machine learning techniques and a database. In the case of items of furniture, windows and/or doors, textures and/or materials can be obtained in a similar way. Furthermore, a texture and/or material recognition integrated into the furniture or object recognition is conceivable.

Moreover, light sources and/or lighting condition may be determined and/or detected in the room 400. By recognizing the light sources in the room (e.g. lamps) as well as the light irradiation from outside (e.g. through windows), the lighting conditions can be estimated at the time of the recording. The user has the possibility to transfer these lighting conditions to the visualized scene or to adapt it according to his wishes or needs.

Further, 3D point clouds or data can be generated from successive frames, with or without depth information. Optionally, segmentation, for example, using deep learning methods (PointNet, PointNet++, ...) can be applied to segment boundaries 405 as instances. Besides 3D point cloud methods, 2D segmentation methods (UNet, Mask RCNN, Detectron2) can also be used as alternative or in addition. 2D and 3D methods can be combined, since 2D masks can be projected directly into the point cloud. However, the use of 2D methods can require a fusion in the point cloud. This can take place, for example, by majority voting.

Based on the 3D data (e.g. point cloud) or 2D image data, it can be decided either for the complete scene or individually per part (from the segmentation) which method should be used to achieve the best geometry reconstruction. Optionally, the parallel use of several methods is also possible. In this case, based on the results, it can be decided which geometry should finally be used for the further procedure.

Here, for example, a metric can be used to arrive at a decision. For the metric, the point cloud and the geometry of the room 400 can be overlaid and the proximity of the points to the generated walls or boundaries 405 can be calculated. The metric can be applied to the complete scene or again to parts.

Preprocessing can optionally be used to transform the raw point cloud into a more suitable shape. This can again be a point cloud. Alternatively, it can be another representation (voxel representation, occupancy map, or the like). In case of creating a new point cloud, a normalization (e.g. discarding points in case of too large number), or a removal of outliers (e.g. removing outlier points) can be applied. In the case of generating an occupancy map of the voxel representation, a machine learning based method can be used. As output of the preprocessing, it is conceivable that only the new representation is provided. It is also conceivable that both data, the input point cloud and the generated representation, are output and passed on to the 3D geometry reconstruction of the room 400.

For example, if only one method was used for the complete scene or reconstruction of the room 400, a fusion of data may not be applied. However, a fusion of data may also be applied in order to merge partial point clouds, for example if panoramic images are taken from different points. In the case where different methods are used, partial scenes can be combined into a single overall scene, and/or a decision can be made as to which reconstruction of an overall or partial scene was most effective. In the case of combination, the individual parts can be transferred into the same 2D or 3D coordinate system. Ideally, no gaps and/or overlaps should occur. In the case that gaps occur due to inaccuracy in the processing, corresponding points (vertices) can be registered to each other. This can mean that either only the corner points can be shifted to a small extent, or that adjacent areas can also shifted or displaced slightly.

In the following, exemplary aspects and possible implementations of the generation of visualization and user interaction are described. The visualization and interaction module may primarily receive the reconstructed 3D scene or scene data as input.

This may contain a parametric model of the room 400, one or more objects 410, 420, such as one or more items of furniture, windows and/or doors, corresponding textures, materials, colors and/or and the reconstructed lighting conditions (e.g. interior lighting and ambient light). If required, an adaptation can be applied by the user. The modeled room can be presented to the user by means of 3D visualization. The user can move freely within the visualized scene of the room 400. Furthermore, the user can interact in order to control further steps regarding the recommender or recommendation engine 520. This can mean, for example, the selection of one or more objects 410, 420 to be re-computed. Likewise, the user can have the room completely refurnished.

Further, the recommender or recommendation engine 520 can return corresponding recommendations, which can be accepted, rejected, modified and/or added to a list of preferred objects by the user. Additionally, the user can change wall colors, as well as adjust textures and/or materials. To make the visualization and interaction as effective as possible in terms of user experience, the user can switch between different perspectives or views. For example, the first-person view, top view, bird's eye view can be selected. In the First Person View, the user can move through the room 400 and perceive it as in reality. The degree of realism can be further increased by using appropriate hardware (e.g. VR goggles).

In the following, exemplary aspects and possible implementations of adjusting and/or modifying the room 400 or scene are described. The room geometry can be adjusted, for example, in the top view/bird's eye view. A room 400 can be represented by a polygon in this view. By moving corners (e.g. click on corner, click on new position), the geometry of room can be adjusted with minimal interaction. Alternatively or additionally, an adjustment via user input of (e.g. re-measured) lengths of walls, angles and/or other numerical measures can be applied.

Further, new corners of the room 400 can be inserted by creating new corner points in the top view by interaction with the user (click on button "new corner point", click into the polygon). Optionally, mansards can be adjusted individually per wall in a 2D projection. In such projection, the wall or boundary 405 can be represented by line segments.

The recommender 520 can receive or process information or data to be considered for computing one or more recommendation for modifying one or more objects 410, 420 in a scene. This can be done by clicking on existing object 410, 420. Then either a new functionally equivalent - or a functionally different object can be selected. Likewise, e.g. in case a gap should be filled, new objects can be defined at certain positions, where again the category (functional) can be selected. Furthermore, it can be selected whether the existing objects 410, 420 should be changed in position by the recommender 520 or not. Also, an interior style can be selected. This can be done via predefined style categories (e.g. country style, Mediterranean, industrial), via selection or adjustment of color schemes, via sample furniture pieces (e.g. sample images), via selection of textual inputs, via various sliders (e.g. progressivity, variability) or any combination of these. Input via mood boards is also possible.

Reconstruction in such form can allow surveying of office facilities, laboratories and industrial sites. For example, the reconstruction can be used to decide whether new machines can fit in existing spaces. Or positioning/configuration can be optimized based on the 3D reconstruction.

Regarding a connection to e-commerce servers 500', this may allow for purchasing objects. In addition, product data can be obtained. This can include, for example, images, 3D models and textual descriptions.

In the following, further exemplary aspects and possible implementations of the recommender or recommendation engine 520 for providing one or more recommendations for modifying a scene are described. The goal of the recommender can be to provide suitable product recommendations for the user based on training data, input from 3D reconstruction, user interaction, and/or external data from e-commerce platforms 500', as illustrated in Figure 7A. For the user, this can mean, for example, selecting a furniture item to be replaced, defining a gap to be filled in the room 400 and the function and/or type of the new furniture item, or completely redesigning an empty or furnished room.

As input from the user, for example, attributes such as type of object or furnishing object, style, material, color, material properties, price range, type of room, object dimensions or any other feature specification are conceivable. Input can, for example, be structured via queries or in the form of textual input.

For example, 3D room dimensions, properties of existing objects, style of objects and categorization of the room in terms of usage can be used as input from the 3D reconstruction. The output of the recommender 520 can be one recommendation or asset, several related recommendations or assets ('bundle') or a sequence of similar recommendations or assets. Typically, this is one or more recommendations for a specific object, e.g. a furnishing item. Likewise, a bundle of recommendations with corresponding recommendation objects can be provided as output by the recommender 520 (e.g. complete seating group, complete living room).

A recommendation or assets can relate to, beyond furnishings, all objects and characteristics or features belonging to a room 400 and/or object 410, 420 that can potentially be changed by the user. This can include, for example, items of furniture (couch, table, chair, groups such as seating groups), object type, lamps (including the properties of the light sources), decorative items, wall colors, ceiling colors, floors, textures, materials, and others.

In a possible implementation, a ranking based on a set of potential recommendations or recommendation objects, e.g. furniture objects can be computed and/or a subset that has optimal fitting or other properties can be selected. Inputs can be on the one hand (one or more) existing (furnishing) objects or room boundaries 405 (i.e. also wall colors, pictures etc.) and on the other hand user input.

In order to find a measure of the fit or similarity (in terms of aesthetics) between different furnishing objects, a technical representation can be used. From the objects (for example in the form of sensor data, or point cloud data) a representation should be extracted that allows a simple, effective metric to compare two or more furnishings. The metric should reflect the distance in terms of aesthetic fit, i.e., be small in the case of high fit and be large in the case of low fit. A reverse behavior is also to be considered equivalent.

To achieve such a metric, deep learning methods can be used which minimize the distance of matching pairs (e.g. L1 norm or L2 norm) in a latent representation and maximize the distance of mismatching pairs (typically with a defined maximum value). For example, Siamese networks can be used for this purpose. Typically, this consists of two Convolutional Neural Networks, with shared weights, encoding an arbitrary dimensional feature in a latent representation. It is further conceivable that describable features are used instead of the hard-to-interpret latent representation. The architectures can include not only image information, but also additional information such as text (e.g. via an encoding like word2vec).

Alternatively or additionally, a classification and/or regression algorithm may be used. Using classical Convolutional Neural Networks (such as ResNet, InceptionNet, SqueezeNet), the style can be predicted as a categorical or continuous variable. For each object type, a data set may be available, which contains for each object a binary or continuous scalar variable that reflects the ground truth.

Further, additional information beyond the image information can be provided as input. This can be unstructured text or image or structured data from a user query. Text can in turn be converted into structured form. Here it is also conceivable that different representations are used to simplify user input. For example, input could also take place via procedures such as mood boards.

A distinction can be made between representations for humans and those for machines. In special cases, these representations can also be identical. The representations can be transformed into each other using learning-based methods, which is favorable to enable parameterization by humans. Transformations between different representations do not necessarily have to be well-defined, but can be ambiguous. For example, there can be several different mood boards for a computer-based representation.

Based on the learned representation and a matching metric (e.g. L1, L2 norm), pairs of objects 410, 420 can now be evaluated with respect to their mutual fit or similarity applying the described similarity metric indicative of the respective measure of similarity considered. In application, this can mean that the representation of each candidate of an object is compared with the existing objects 410, 420, for example with each existing object or object arranged in the room or scene.

As an optimization, the neural network can directly receive a set of objects as input. Technically, this can be accomplished, for example, by defining multiple network channels as input, which are fused within the network. It is also conceivable that latent representations of multiple objects or object features are aggregated (e.g., using methods such as bag-of-words or statistical descriptors such as mean/median and variance/quartile range), in which case the aggregation corresponds to the set of objects or object features as a whole (also referred to as feature vector herein). This may or may not be coherent (e.g. represented in a continuum between 0 and 1). Likewise, this can correspond to a style or more generally to the desire of the user (continuum [0,1]). These continuous variables can be used to train machine learning methods and to apply them (from trained models). As an alternative approach, auto encoders or long-short-term memory networks (LSTMs) can be used to determine recommendations. Autoencoders, e.g. can estimate missing items or objects (e.g. of furniture) based on a set of given items or objects.

The recommender 520 is not limited to items of furniture por specific objects, but can also be used in other rooms 400 or for any other object 410, 420. While the focus may primarily be on providing stylistically appropriate recommendations for furnishings, the method can also be used to optimize routes, for example. This can play a role in living spaces as well as in offices, industrial facilities or hospitals/laboratories. Since the system is data-driven, the behavior of the system can be adapted by adjusting the training data.

In the following, exemplary aspects and possible implementations of a feedback loop for generating training data are described, as particularly illustrated in Figure 7A. The operational use of the system 1000 can generate feedback from the user, which can then be used to incrementally improve the system. This applies on the one hand to the 3D reconstruction and on the other hand to the recommender.

Feedback can be used directly to optimize and extend the training database. For instance, regarding 3D reconstruction the user can correct errors in an automatic process through simple intuitive interaction. This applies for example to wrongly positioned elements or objects like doors, windows or walls. Likewise, incorrectly detected other objects, e.g. items of furniture, can be compensated for by the user. By hinting, the user can be encouraged to check the reconstruction for correctness. This hint can take place either always or in case of uncertainties in the technical process. Thus, the pair consisting of sensor data and user-confirmed 3D reconstruction can be used for future optimization of data-driven 3D reconstruction.

As data usable for this purpose, the generated RGB or RGB+D frames or the point cloud are available as data. Furthermore, the correctly created or corrected parametric model, e.g. 3D model, of the room 400 is available. The 3D model can consist of segments of planes, cylinders, spheres and cones. There can also exist only the top view described by 2D segments (straight lines, circle segments, or the like).

Correction and/or modification of the room geometry can be performed by the user based on activating a projection onto the floor plan. By means of this top view, individual points of the room or boundaries 405 thereof and/or objects 410, 420 can be activated and moved. The presence of roof slopes (mansard) can also be manually added to the model or scene by user input. For this purpose, a wall can be selected and a mansard height and angle can be defined. Incorrectly placed windows and doors can also be corrected in the top view with regard to their vertical position. A horizontal correction based on manual input is also conceivable. Finally, the insertion and/or replacement of windows and doors is also conceivable. It is also conceivable that incorrectly detected furnishings or objects such as tables, chairs and couches can be corrected manually. For this purpose, the recognized object 410, 420 can be selected and replaced by interaction with another object or removed completely. Finally, an insertion of falsely non-recognized objects is also conceivable.

The recommender 520 can provide the user with various product recommendations, which the user can accept or reject. It is also conceivable that the user can add items or objects to a list that is specified as a shortlist. It is also conceivable that the user rates recommendations using a scale (e.g., 1-5 stars, thumbs up/thumbs down/neutral). Further feedback can be given by purchase completions. All of these options generate feedback on the product recommendations, which in the context of learning systems can be used as ground truth and thus for incremental optimization of the overall system 1000. The feedback can also be used to learn the user's preferences.

All data obtained through user feedback can in principle be used directly to train the model. However, there is a possibility that data not intended in this way may negatively affect the model. This can be due to incorrect operation of the system by the user, unintentionally incorrect measurement or incorrect input of data by the use, or an intended wrong input as attack vector.

To cover these cases, data cleansing can be applied. This can be done on the one hand by a human observer or by an automated system or in a hybrid way. In an automated way, for example, it is possible to check whether corrected walls or windows correspond to points in the point cloud. Likewise, the machine learning model can be used to verify whether replaced objects are plausible/probable. For this purpose, anomaly detection methods can be used, for example. In addition, checks that exclude implausible spatial geometry can be performed. Manual checks can utilize the visualization of the input data (point cloud and RGB images) as well as the generated models. Crowdsourcing solutions such as Amazon Mechanical Turk are suitable for this purpose. The hybrid approach can combine both variants. Using intelligent automated methods, a large number of corrections can already be confirmed. Questionable cases may further be evaluated by human observers.

In the following, exemplary aspects and possible implementations related to data transmission are described. The different processes can be performed on different devices or entities, such as a user device 100, one or more servers 500, 500' or other computing devices.

Sensor data from the scan can be sent in part or completely from the user device 100 to a cloud instance or server 500 for reconstruction and/or retrieval. This can either be (raw) sensor data or data that has already been preprocessed. In the latter case, for example, a 3D point cloud can be transmitted.

For the visualization, the processed data can be transmitted back to the user device 100. This can involve one or more of 3D model data of the room geometry (parametric model (CAD-Like) or alternatively a mesh), segmentation data and/or data related to detection of windows and doors, optionally including reference to the respective models in a database as well as position and orientation (6 DoF, Degrees of Freedom) and possibly scaling (2 or 3 DoFs).

Further, detected objects, e.g. items of furniture, can be translated into 3D models (points and orientation (6 DoF)) of detected objects, possibly involving scaling (3 DoFs) reference to the specific objects) and corresponding data can be transmitted to the user device 100.

Further, the scene or scene data can be visualized for the user on the user device 100 using this data. Unity or Unreal, for example, are suitable tools for this. Beyond the pure visualization, the user can interact with the scene, move around in the scene and make adjustments to the scene.

The interaction can also be used to define product proposals or recommendations, e.g. on how the proposal for a new product or object should be made. For example, the user can select which object or objects should be replaced, where a new object should be inserted, or whether the room should be completely redecorated. Wall colors can also be selected by the user. Such information can be transmitted to a cloud instance or server 500 together with the models calculated from the reconstruction/retrieval and user preferences.

A recommendation for an object can be calculated in the cloud instance or server 500. This can be either a single object or several objects. A ranking of objects can be applied as an option. Further, the recommendation engine 520 can be used not only for furnishings, but also for attributes such as colors or decorative items. To generate product or object recommendations, a database connection to existing articles, objects or products can be used. This can be one's own system, or a third-party system of a supplier of furnishing items/colors/decoration/lamps. An adapter is also conceivable here, which adapts the interfaces of third-party providers so that they are compatible with the company's own interface.

Recommendations can be transferred back to the user device 100 to be visualized there. The visualized products or objects can finally be purchased there. The purchase transaction can take place directly in the application. Alternatively, the user can be redirected to the web store of the supplier of the product or object.

Feedback from the user can be used to enrich the database. For this purpose, 3D models adjusted and thus corrected by the user can be transmitted to a cloud instance or server 500. This can be the reconstruction component of the system 1000. For later use, the corrected model can be stored together with the (raw) sensor data. The storage can take place in another component.

Likewise, feedback can flow back to the recommender 520, and an evaluation of recommendations can be used directly as ground truth. For example, feedback can flow to the recommender, where it can be stored together with the input data in another component.

While the invention has been illustrated and described in detail in the drawings and foregoing description, such illustration and description are to be considered illustrative or exemplary and not restrictive; the invention is not limited to the disclosed embodiments.

In the claims, the word "comprising" does not exclude other elements or steps, and the indefinite article "a" or "an" does not exclude a plurality. Any reference signs in the claims should not be construed as limiting the scope.

Furthermore, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

## Claims

1. A computer-implemented method of reconstructing an interior room, the method comprising:
receiving sensor data indicative of at least one image of at least a part of a room acquired with at least one image sensor of a user device;
determining, based on the sensor data, at least a part of a point cloud representative of the at least part of the room and representative of one or more objects arranged in the room, wherein at least one of the one or more objects is associated with an item of furniture arranged in the room;
detecting, based on the determined point cloud, one or more objects arranged in the room;
associating the detected one or more objects with one or more reference objects indicative of one or more reference items of furniture;
determining one or more parametric models for the detected one or more objects; and
reconstructing at least a part of the room based on the determined one or more parametric models for the detected one or more objects;
the method further comprises determining, based on processing the point cloud, sensor data and/or one or more images indicative of the one or more objects arranged in the room, materials of the one or more objects arranged in the room;
retrieving, from a database storing a plurality of reference materials of reference objects, materials data resembling the determined one or more materials of one or more objects arranged in the room;
reconstructing the room based on the retrieved material data.

2. The method according to claim 1, wherein detecting the one or more objects includes:
detecting, based on the determined point cloud, one or more of a location, an orientation, and a type of the one or more objects arranged in the room.

3. The method according to any one of the preceding claims, further comprising:
segmenting the at least one portion of the point cloud using one or more segmentation algorithms, preferably wherein the at least one portion of the point cloud is segmented by means of semantic segmentation, instance segmentation and/or panoptic segmentation.

4. The method according to any one of the preceding claims,
wherein the at least one portion of the point cloud is processed based on one or more of object detection, object retrieval, and/or pose estimation.

5. The method according to any one of the preceding claims, further comprising:
generating segmented data based on segmenting one or more of the sensor data, the at least one image of the interior room indicated by the sensor data, further sensor data, and/or one or more further images of the interior room,
preferably wherein the segmented data is generated based on selecting one or more algorithms for semantic segmentation, instance segmentation and/or panoptic segmentation.

6. The method according to any one of the preceding claims, further comprising:
transforming and/or converting the generated segmented data into the determined point cloud of the interior room.

7. The method according to any one of claims 3 to 6, further comprising:
detecting and/or identifying one or more objects arranged in the room based on the segmented at least one portion of the point cloud.

8. The method according to any one of the preceding claims,
wherein the detected one or more objects are associated with one or more reference objects based on image retrieval and/or point cloud retrieval utilizing a database storing a plurality of reference objects indicative of a plurality of reference items of furniture, optionally wherein the detected one or more objects are associated with the one or more reference objects based on deep learning.

9. The method according to any one of the preceding claims, further comprising:
retrieving, from a database storing a plurality of reference objects one or more parametric models for the detected one or more objects.

10. The method according to claim 9, further comprising:
adjusting one or more parameters of the retrieved one or more parametric models, such that each of the parametric models corresponds in shape, geometry, material and/or size to the corresponding detected one or more objects arranged in the room.

11. The method according to any one of claims 9 and 10,
wherein detecting the one or more objects comprises determining one or more reference points of the of the one or more objects; and
wherein the one or more parameters of the determined one or more parametric models are adjusted based on the determined one or more reference points of the one or more objects.

12. The method according to any one of the preceding claims, further comprising:
determining a mesh representation and/or voxel representation for one or more of the detected objects.

13. The method according to any one of the preceding claims, further comprising:
detecting and/or identifying one or more light sources arranged in the room and/or outside the room and/or illuminating the room.

14. A computing system, comprising:
at least one computing device configured to perform ef the method according to any one of the preceding claims.

15. The computing system according to claim 14, comprising:
at least one server; and
at least one user device communicatively couplable to the at least one server.

16. A computer program, which, when executed on a computing device or system, instructs the computing device or system to carry out the method according to any one of claims 1 to 13.

17. A computer-readable medium having stored thereon a computer program according to claim 16.

## Patentansprüche

1. Ein computerimplementiertes Verfahren zur Rekonstruktion eines Innenraums, wobei das Verfahren Folgendes umfasst:
Empfangen von Sensordaten, die auf wenigstens ein Bild von wenigstens einem Teil eines Raums hinweisen, das mit wenigstens einem Bildsensor eines Benutzergeräts erfasst wurde;
Bestimmen, basierend auf den Sensordaten, wenigstens eines Teils einer Punktewolke, die für den wenigstens einen Teil des Raums und für ein oder mehrere im Raum angeordnete Objekte repräsentativ ist, wobei wenigstens eines des einen oder der mehreren Objekte mit einem im Raum angeordneten Möbelstück in Verbindung gebracht wird;
Erfassen, basierend auf der ermittelten Punktewolke, eines oder mehrerer im Raum angeordneter Objekte;
Zuordnen des einen oder der mehreren erkannten Objekte zu einem oder mehreren Referenzobjekten, die auf ein oder mehrere Referenzmöbelstücke hinweisen;
Bestimmen eines oder mehrerer parametrischer Modelle für das erfasste eine oder die mehreren Objekte; und
Rekonstruieren wenigstens eines Teils des Raums basierend auf dem bestimmten einen oder mehreren parametrischen Modellen für das erfasste eine oder die mehreren Objekte;
das Verfahren ferner umfassend Bestimmen, basierend auf einer Verarbeitung der Punktewolke, von Sensordaten und/oder einem oder mehreren Bildern, die auf das eine oder die mehreren im Raum angeordneten Objekte, Materialien des einen oder der mehreren im Raum angeordnete Objekte hinweisen;
Abrufen von Materialdaten aus einer Datenbank, auf der eine Vielzahl von Referenzmaterialien von Referenzobjekten gespeichert sind, die dem bestimmten einen oder mehreren Materialien einer oder mehrerer im Raum angeordneter Objekte ähneln;
Rekonstruieren des Raums basierend auf den abgerufenen Materialdaten.

2. Verfahren nach Anspruch 1, wobei das Erfassen des einen oder der mehreren Objekte Folgendes beinhaltet:
Erfassen, basierend auf der ermittelten Punktewolke, eines oder mehrerer von einem Ort, einer Ausrichtung und einem Typ des einen oder der mehreren im Raum angeordneten Objekte.

3. Verfahren nach einem der vorhergehenden Ansprüche, ferner umfassend:
Segmentieren des wenigstens einen Teils der Punktewolke unter Verwendung eines oder mehrerer Segmentierungsalgorithmen, vorzugsweise wobei der wenigstens eine Teil der Punktewolke mittels semantischer Segmentierung, Instanzsegmentierung und/oder panoptischer Segmentierung segmentiert wird.

4. Verfahren nach einem der vorhergehenden Ansprüche,
wobei der wenigstens eine Teil der Punktewolke basierend auf einem oder mehreren von Objekterkennung, Objektabfrage und/oder Posenschätzung verarbeitet wird.

5. Verfahren nach einem der vorhergehenden Ansprüche, ferner umfassend:
Erzeugen segmentierter Daten basierend auf der Segmentierung von einem oder mehreren von den Sensordaten, dem wenigstens einen Bild des durch die Sensordaten angegebenen Innenraums, weiteren Sensordaten und/oder ein oder mehrere weitere Bilder des Innenraums,
vorzugsweise wobei die segmentierten Daten basierend auf der Auswahl eines oder mehrerer Algorithmen zur semantischen Segmentierung, Instanzsegmentierung und/oder panoptischen Segmentierung generiert werden.

6. Verfahren nach einem der vorhergehenden Ansprüche, ferner umfassend:
Transformieren und/oder Konvertieren der generierten segmentierten Daten in die ermittelte Punktewolke des Innenraums.

7. Verfahren nach einem der Ansprüche 3 bis 6, ferner umfassend:
Erkennen und/oder Identifizieren eines oder mehrerer im Raum angeordneter Objekte basierend auf dem segmentierten wenigstens einen Teil der Punktewolke.

8. Verfahren nach einem der vorhergehenden Ansprüche,
wobei das eine oder die mehreren erfassten Objekte einem oder mehreren Referenzobjekten zugeordnet werden, basierend auf Bildabruf und/oder Punktewolkenabruf unter Verwendung einer Datenbank, in der eine Vielzahl von Referenzobjekten gespeichert sind, die auf eine Vielzahl an Referenzmöbelstücken hinweisen, wobei optional das oder die erfassten ein oder mehreren Objekte auf Basis von Deep Learning dem einen oder den mehreren Referenzobjekten zugeordnet werden.

9. Verfahren nach einem der vorhergehenden Ansprüche, ferner umfassend:
Abrufen eines oder mehrerer parametrischer Modelle für das oder die erfassten Objekte aus einer Datenbank, in der eine Vielzahl von Referenzobjekten gespeichert sind.

10. Verfahren nach Anspruch 9, ferner umfassend:
Anpassen eines oder mehrerer Parameter des abgerufenen einen oder der mehreren parametrischen Modelle, sodass jedes der parametrischen Modelle in Form, Geometrie, Material und/oder Größe dem entsprechenden erfassten einen oder mehreren im Raum angeordneten Objekten entspricht.

11. Verfahren nach einem der Ansprüche 9 und 10,
wobei das Erfassen des einen oder der mehreren Objekte das Bestimmen eines oder mehrerer Referenzpunkte des einen oder der mehreren Objekte umfasst; und
wobei der eine oder die mehreren Parameter des bestimmten einen oder der mehreren parametrischen Modelle basierend auf dem bestimmten einen oder den mehreren Referenzpunkten des einen oder der mehreren Objekte angepasst werden.

12. Verfahren nach einem der vorhergehenden Ansprüche, ferner umfassend:
Bestimmen einer Netzdarstellung und/oder Voxeldarstellung für eines oder mehrere der erkannten Objekte.

13. Verfahren nach einem der vorhergehenden Ansprüche, ferner umfassend:
Erkennen und/oder Identifizieren einer oder mehrerer im Raum und/oder außerhalb des Raumes angeordneter und/oder den Raum beleuchtende Lichtquellen.

14. Ein Computersystem, umfassend:
wenigstens ein Computergerät, das dazu konfiguriert ist, das Verfahren nach einem der vorhergehenden Ansprüche auszuführen.

15. Computersystem nach Anspruch 14, umfassend:
wenigstens einen Server; und
wenigstens ein Benutzergerät, das kommunikativ mit dem wenigstens einen Server koppelbar ist.

16. Ein Computerprogramm, das, wenn es auf einem Computergerät oder -system ausgeführt wird, das Computergerät oder -system anweist, das Verfahren nach einem der Ansprüche 1 bis 13 auszuführen.

17. Ein computerlesbares Medium, auf dem ein Computerprogramm nach Anspruch 16 gespeichert ist.

## Revendications

1. Procédé mis en oeuvre par ordinateur permettant de reconstruire une pièce intérieure, le procédé comprenant :
la réception de données de capteur indiquant au moins une image d'au moins une partie d'une pièce acquise avec au moins un capteur d'image d'un dispositif utilisateur ;
la détermination, sur la base des données de capteur, d'au moins une partie d'un nuage de points représentative de l'au moins une partie de la pièce et représentative d'un ou plusieurs objets disposés dans la pièce, dans lequel au moins un objet parmi l'objet ou les plusieurs objets est associé à un meuble disposé dans la pièce ;
la détection, sur la base du nuage de points déterminé, d'un ou plusieurs objets disposés dans la pièce ;
l'association de l'objet ou des objets détectés à un ou plusieurs objets de référence indiquant un ou plusieurs meubles de référence ;
la détermination d'un ou plusieurs modèles paramétriques pour l'objet ou les objets détectés ; et
la reconstruction d'au moins une partie de la pièce sur la base du ou des modèles paramétriques déterminés pour l'objet ou les objets détectés ;
le procédé comprend en outre la détermination, sur la base d'un traitement du nuage de points, des données de capteur et/ou une ou plusieurs images indiquant l'objet ou les objets disposés dans la pièce, de matériaux de l'objet ou des objets disposés dans la pièce ;
la récupération, à partir d'une base de données stockant une pluralité de matériaux de référence d'objets de référence, des données de matériaux ressemblant au ou aux matériaux déterminés d'un ou plusieurs objets disposés dans la pièce ;
la reconstruction de la pièce sur la base des données de matériaux récupérées.

2. Procédé selon la revendication 1, dans lequel la détection de l'objet ou des objets inclut :
la détection, sur la base du nuage de points déterminé, d'un ou plusieurs éléments parmi un emplacement, une orientation et un type de l'objet ou des objets disposés dans la pièce.

3. Procédé selon l'une quelconque des revendications précédentes, comprenant en outre :
la segmentation de l'au moins une portion du nuage de points en utilisant un ou plusieurs algorithmes de segmentation, de préférence dans lequel l'au moins une portion du nuage de points est segmentée au moyen d'une segmentation sémantique, d'une segmentation par instance et/ou d'une segmentation panoptique.

4. Procédé selon l'une quelconque des revendications précédentes,
dans lequel l'au moins une portion du nuage de points est traitée sur la base d'un ou plusieurs éléments parmi une détection d'objet, une récupération d'objet et/ou une estimation de pose.

5. Procédé selon l'une quelconque des revendications précédentes, comprenant en outre :
la génération des données segmentées sur la base de la segmentation d'un ou plusieurs éléments parmi les données de capteur, l'au moins une image de la pièce intérieure indiquée par les données de capteur, des données de capteur supplémentaires et/ou une ou plusieurs images supplémentaires de la pièce intérieure,
de préférence dans lequel les données segmentées sont générées sur la base de la sélection d'un ou plusieurs algorithmes de segmentation sémantique, de segmentation par instance et/ou de segmentation panoptique.

6. Procédé selon l'une quelconque des revendications précédentes, comprenant en outre :
la transformation et/ou la conversion des données segmentées générées en le nuage de points déterminé de la pièce intérieure.

7. Procédé selon l'une quelconque des revendications 3 à 6, comprenant en outre :
la détection et/ou l'identification d'un ou plusieurs objets disposés dans la pièce sur la base de l'au moins une portion segmentée du nuage de points.

8. Procédé selon l'une quelconque des revendications précédentes,
dans lequel l'objet ou les objets détectés sont associés à un ou plusieurs objets de référence sur la base d'une récupération d'image et/ou d'une récupération de nuage de points en utilisant une base de donnée stockant une pluralité d'objets de référence indiquant une pluralité de meubles de référence, éventuellement dans lequel l'objet ou les objets détectés sont associés à l'objet ou aux objets de référence sur la base d'un apprentissage profond.

9. Procédé selon l'une quelconque des revendications précédentes, comprenant en outre :
la récupération, à partir d'une base de données stockant une pluralité d'objets de référence, d'un ou plusieurs modèles paramétriques pour l'objet ou les objets détectés.

10. Procédé selon la revendication 9, comprenant en outre :
le réglage d'un ou plusieurs paramètres du ou des modèles paramétriques récupérés, de telle sorte que chacun des modèles paramétriques correspond en termes de forme, de géométrie, de matériau et/ou de taille à l'objet ou aux objets détectés correspondants disposés dans la pièce.

11. Procédé selon l'une quelconque des revendications 9 et 10, dans lequel la détection de l'objet ou des objets comprend la détermination d'un ou plusieurs points de référence de l'objet ou des objets ; et
dans lequel le ou les paramètres du ou des modèles paramétriques déterminés sont réglés sur la base du ou des points de référence déterminés de l'objet ou des objets.

12. Procédé selon l'une quelconque des revendications précédentes, comprenant en outre :
la détermination d'une représentation par maillage et/ou d'une représentation par voxels pour un ou plusieurs des objets détectés.

13. Procédé selon l'une quelconque des revendications précédentes, comprenant en outre :
la détection et/ou l'identification d'une ou plusieurs sources de lumière disposées dans la pièce et/ou à l'extérieur de la pièce et/ou éclairant la pièce.

14. Système informatique, comprenant :
au moins un dispositif informatique configuré pour exécuter le procédé selon l'une quelconque des revendications précédentes.

15. Système informatique selon la revendication 14, comprenant :
au moins un serveur ; et
au moins un dispositif utilisateur pouvant être couplé en communication à l'au moins un serveur.

16. Programme informatique qui, lorsqu'il est exécuté sur un dispositif ou un système informatique, donne instruction au dispositif ou au système informatique d'exécuter le procédé selon l'une quelconque des revendications 1 à 13.

17. Support lisible par ordinateur sur lequel est stocké un programme informatique selon la revendication 16.
